(19) **Europäisches Patentamt** / **European Patent Office** / **Office européen des brevets**

(11) **EP 3 474 439 B1**

(12) **FASCICULE DE BREVET EUROPEEN**

(45) Date de publication et mention
de la délivrance du brevet:
**15.07.2020 Bulletin 2020/29**

(51) Int Cl.:
*H02S 50/00* (2014.01) *H02S 50/10* (2014.01)

(21) Numéro de dépôt: **18199379.1**

(22) Date de dépôt: **09.10.2018**

(54) **PROCÉDÉ DE CARACTÉRISATION ÉLECTRIQUE D'UNE CELLULE PHOTOVOLTAÏQUE**

VERFAHREN ZUR ELEKTRISCHEN CHARACTERISIERUNG EINER SOLARZELLE

METHOD FOR ELECTRICAL CHARACTERISATION OF A PHOTOVOLTAIC CELL

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **23.10.2017 FR 1759997**

(43) Date de publication de la demande:
**24.04.2019 Bulletin 2019/17**

(73) Titulaire: **Commissariat à l'Énergie Atomique
et aux Énergies Alternatives
75015 Paris (FR)**

(72) Inventeurs:
• **AL SHAKARCHI, Franck
73160 SAINT-SULPICE (FR)**
• **HA, Duy Long
73000 CHAMBERY LE VIEUX (FR)**

(74) Mandataire: **GIE Innovation Competence Group
310, avenue Berthelot
69372 Lyon Cedex 08 (FR)**

(56) Documents cités:
**JP-A- 2003 324 207     US-A1- 2015 094 967
US-A1- 2017 063 304**

EP 3 474 439 B1

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

Printed by Jouve, 75001 PARIS (FR)

**Description**

**Domaine technique de l'invention**

La présente invention se rapporte à un procédé de caractérisation électrique d'une cellule photovoltaïque d'un module photovoltaïque.

L'invention concerne également un système de caractérisation électrique d'une cellule photovoltaïque d'un module photovoltaïque.

**Etat de la technique**

Une architecture photovoltaïque comporte en règle générale plusieurs chaînes de modules photovoltaïques (appelés également panneaux photovoltaïques ou panneaux solaires) connectés en parallèle. Dans chaque chaîne, les modules photovoltaïques sont connectés en série. Chaque module photovoltaïque comporte plusieurs cellules photovoltaïques connectées en série, sous forme de rangées de cellules. Chaque cellule photovoltaïque est destinée à convertir une énergie solaire en une énergie électrique. Les chaînes de modules photovoltaïques sont reliées à un convertisseur de tension, comme par exemple un onduleur qui permet de convertir la tension continue fournie par chaque chaîne de modules en une tension alternative. Le rôle du convertisseur est également de déterminer un point de fonctionnement pour lequel la puissance délivrée par l'ensemble de l'architecture photovoltaïque est maximale (point de fonctionnement maximal désigné MPP pour "Maximum Power Point").

La présence d'un défaut dans une chaîne de modules photovoltaïques handicape la production d'électricité de toute la chaîne et donc de toute l'architecture de production d'électricité. Le document US2015/094967A décrit un procédé de caractérisation d'une cellule photovoltaïque.

Il est donc nécessaire de surveiller l'état de fonctionnement de chaque module photovoltaïque d'une chaîne afin de repérer un éventuel défaut au niveau d'un module et d'y pallier le plus rapidement possible. Selon les cas, le défaut pourra être de différentes natures, notamment permanent s'il s'agit d'un problème matériel ou temporaire s'il s'agit par exemple de la présence d'un ombrage ou d'une poussière sur le module.

Pour détecter les défauts de fonctionnement des modules, plusieurs solutions de surveillance ont déjà été proposées. Les demandes de brevets US2015/094967A1, WO2012/128807A1, FR2956213A1, WO2010/118952A1, US9048781B2 ou US2014/266294A1 décrivent toutes des solutions de ce type. Afin de vérifier l'état de fonctionnement d'un module, la plupart des solutions se base notamment sur l'analyse des courbes Courant-Tension, plus communément appelées courbes I-V.

Un module photovoltaïque est en effet caractérisé par un ensemble de courbes I-V de référence pour différents niveaux d'ensoleillement (exprimés en Watt/m$^2$). Autrement dit, pour un niveau d'ensoleillement donné, un module photovoltaïque sain, c'est-à-dire non défaillant, sera théoriquement capable de suivre l'une des courbes I-V de référence pour ce niveau d'ensoleillement. En revanche, si un module présente un défaut en fonctionnement, sa courbe I-V s'éloigne alors de cette courbe de référence pour ce niveau d'ensoleillement.

Dans la plupart des solutions décrites dans les documents brevets référencés ci-dessus, la courbe I-V d'un module est déterminée en employant plusieurs capteurs, notamment un capteur de courant pour chaque module, ce qui complexifie l'architecture et augmente son coût. Pour déterminer l'état de fonctionnement d'un module, certaines solutions nécessitent également de couper la production électrique de la chaîne.

Aujourd'hui, il n'existe donc pas de solutions simples qui permettent de déterminer la courbe I-V d'un module photovoltaïque, sans employer de capteur de courant, ni de tension.

Le but de l'invention est donc de proposer une solution qui puisse remplir cet objectif.

Par la caractérisation électrique de chaque cellule photovoltaïque d'un module photovoltaïque, il sera ainsi possible de déterminer les propriétés électriques du module photovoltaïque dans sa globalité.

**Exposé de l'invention**

Ce but est atteint par un procédé de caractérisation électrique d'une cellule photovoltaïque d'un module photovoltaïque, ledit module photovoltaïque comportant plusieurs cellules photovoltaïques connectées entre elles et une ou plusieurs diodes de contournement, chaque diode de contournement étant configurée pour contourner un sous-module formé d'une ou plusieurs cellules photovoltaïques dudit module photovoltaïque, ledit procédé comportant des étapes de :

- Obtention de l'irradiance reçue par ledit module photovoltaïque,
- Obtention d'une température de chaque cellule photovoltaïque d'un premier sous-module dudit module photovoltaïque,

- Comparaison de ladite température obtenue pour chaque cellule photovoltaïque du premier sous-module avec une température de référence,
- Détermination de l'état de chaque cellule photovoltaïque du premier sous-module entre un état sain pour lequel sa température est égale à la température de référence et un état en défaut pour lequel sa température est différente de ladite température de référence,
- Estimation de la courbe I-V associée à une première cellule photovoltaïque dudit premier sous-module, par recherche dans une base de données de courbes I-V, en tenant compte de :

    ◦ L'état sain ou de l'état en défaut de ladite première cellule photovoltaïque ;
    ◦ L'état sain ou de l'état en défaut de toutes les autres cellules photovoltaïques du premier sous-module ;
    ◦ La puissance électrique fournie par chaque cellule photovoltaïque du premier sous-module.

Selon une particularité :

- Si la première cellule photovoltaïque est dans ledit état en défaut, il comporte une étape de :
    ◦ Détermination si la première cellule photovoltaïque appartient à une chaîne de modules dans laquelle toutes les cellules photovoltaïques sont dans l'état en défaut ou si la première cellule photovoltaïque appartient à une chaîne de modules dans laquelle au moins une cellule photovoltaïque est dans un état sain.

Selon une autre particularité :

- Si la première cellule photovoltaïque appartient à une chaîne de modules dans laquelle au moins une cellule photovoltaïque est dans un état sain, il comporte une étape de :
    ◦ Détermination si la première cellule photovoltaïque appartient à un sous-module qui comporte au moins une cellule dans l'état sain ou à un sous-module qui ne comporte aucune cellule à l'état sain.

Selon une autre particularité :

- Si la première cellule photovoltaïque appartient à un sous-module qui comporte au moins une cellule à l'état sain, il comporte une étape de :
    ◦ Comparaison de la température de la première cellule avec ladite température de référence pour déterminer si ladite température de la première cellule est supérieure à ladite température de référence ou inférieure à ladite température de référence.

Selon une autre particularité :

- Si la température de la première cellule photovoltaïque est inférieure à la température de référence, il consiste à mettre en œuvre une boucle de recherche de la courbe I-V associée à ladite première cellule photovoltaïque, ladite boucle de recherche comprenant :

    ◦ Une étape d'application d'une première irradiance ;
    ◦ Une étape de détermination dans la base de données de courbes I-V d'une première courbe I-V correspondant à ladite première irradiance et à ladite température de la première cellule photovoltaïque ;
    ◦ A partir de ladite première courbe, une étape de détermination de la tension qui correspond au courant au point de fonctionnement maximal ;
    ◦ Une étape de vérification de la relation suivante :

$$G = P_{th\_cell\_k} + I_{mpp} \times V(I_{mpp})$$

Dans laquelle :

- G correspond à ladite première irradiance introduite en entrée ;
- $P_{th\_cell\_k}$ correspond à la puissance thermique générée par ladite première cellule photovoltaïque ;
- $I_{mpp}$ correspond au courant au point de fonctionnement maximal ;
- $V(I_{mpp})$ correspond à la tension déterminée sur ladite première courbe I-V pour ledit courant au point de fonctionnement maximal ;

◦ Si ladite relation est vérifiée, ladite courbe I-V est valide ;

◦ Si ladite relation n'est pas vérifiée, ladite boucle est recommencée en modifiant la valeur de l'irradiance appliquée en entrée.

Selon une autre particularité :

- Si la température de la première cellule photovoltaïque est supérieure à la température de référence, il comporte :

◦ Une étape de détermination de la tension de la première cellule photovoltaïque en défaut à partir de la relation suivante :

$$V_{cell\_k} = V_{mpp} - \Delta P_{th\_cell\_k} / I_{mpp}$$

Dans laquelle :

- $V_{cell\_k}$ correspond à la tension de la première cellule photovoltaïque ;
- $V_{mpp}$ correspond à la tension au point de fonctionnement maximal ;
- $\Delta P_{th\_cell\_k}$ correspond aux pertes énergétiques occasionnés par la première cellule photovoltaïque en défaut ;
- $I_{mpp}$ correspond au courant au point de fonctionnement maximal ;

◦ Une étape de recherche dans la base de données de courbes I-V de la courbe I-V qui correspond à une irradiance de référence, et pour laquelle le point ayant pour coordonnées ladite tension déterminée pour la première cellule photovoltaïque et le courant au point de fonctionnement maximal appartient à la courbe.

Selon une autre particularité :

- Si la première cellule photovoltaïque appartient à un sous-module qui ne comporte aucune cellule à l'état sain, il comporte une étape de :
◦ Détermination si toutes les cellules de son sous-module présentent une puissance électrique nulle ou si au moins une cellule dudit sous-module présente une puissance électrique non-nulle.

Selon une autre particularité :

- Si toutes les cellules de son sous-module présentent une puissance électrique nulle, il comporte une étape de :
◦ Estimation de la courbe I-V associée à ladite première cellule photovoltaïque par recherche dans une base de données de courbes I-V d'une courbe I-V définie par {(*I,V*) *tel que I* $\geq$ 0 *et V* = 0} et {(*I,V*) *tel que I* = 0 *et V* $\geq$ 0} ;

Selon une autre particularité :

- Si au moins une cellule dudit sous-module présente une puissance électrique non nulle, il consiste à mettre en œuvre une boucle de recherche de la courbe I-V associée à ladite première cellule photovoltaïque, ladite boucle de recherche comprenant :

◦ Une étape d'application d'un premier courant ;
◦ Une étape de détermination, pour chaque cellule photovoltaïque dudit sous-module, de la tension de la cellule à partir de la relation suivante :

$$V_{cell\_k}(I_{in}) = (P_{elec\_sain} - \Delta P_{th\_cell\_k}) / I_{in}$$

Dans laquelle :

- $V_{cell\_k}$ correspond à la tension de la chaque cellule photovoltaïque dudit sous-module, avec k=1 à n cellules photovoltaïques dans le sous-module ;
- $I_{in}$ correspond audit premier courant appliqué en entrée ;

- $P_{elec\_sain}$ correspond à la puissance fournie par une cellule photovoltaïque dans un état sain ;
- $\Delta P_{th\_cell\_k}$ correspond aux pertes énergétiques occasionnés par chaque cellule photovoltaïque en défaut ;

  ◦ Une étape de détermination de la somme des tensions de toutes les cellules photovoltaïques du sous-module ;
  ◦ Une étape de vérification si ladite somme est nulle ou non nulle ;
  ◦ Si ladite somme est nulle :
  - Une étape d'estimation de la courbe I-V associée à ladite première cellule photovoltaïque par recherche dans une base de données de courbes I-V d'une courbe I-V pour laquelle le point ayant pour coordonnées ladite tension déterminée pour la première cellule photovoltaïque et le premier courant appliqué en entrée appartient à la courbe ;
  ◦ Si ladite somme est non nulle :
  - Une étape de modification du premier courant appliqué en entrée et de nouvelle mise en œuvre de ladite boucle de recherche en tenant compte du premier courant modifié.

L'invention concerne également un système de caractérisation électrique d'une cellule photovoltaïque d'un module photovoltaïque, ledit module photovoltaïque comportant plusieurs cellules photovoltaïques connectées entre elles et une ou plusieurs diodes de contournement, chaque diode de contournement étant configurée pour contourner un sous-module formé d'une ou plusieurs cellules photovoltaïques dudit module photovoltaïque, le système comportant :

- Un module d'obtention de l'irradiance reçue par ledit module photovoltaïque,
- Un module d'obtention d'une température de chaque cellule photovoltaïque d'un premier sous-module dudit module photovoltaïque,
- Un module de comparaison de ladite température obtenue pour chaque cellule photovoltaïque du premier sous-module avec une température de référence,
- Un module de détermination de l'état de chaque cellule photovoltaïque du premier sous-module entre un état sain pour lequel sa température est égale à la température de référence et un état en défaut pour lequel sa température est différente de ladite température de référence,
- Un module d'estimation de la courbe I-V associée à une première cellule photovoltaïque dudit premier sous-module, par recherche dans une base de données de courbes I-V, en tenant compte de :

  ◦ L'état sain ou de l'état en défaut de ladite première cellule photovoltaïque ;
  ◦ L'état sain ou de l'état en défaut de toutes les autres cellules photovoltaïques du premier sous-module ;
  ◦ La puissance électrique fournie par chaque cellule photovoltaïque du premier sous-module.

Selon une particularité :

- Si la première cellule photovoltaïque est dans ledit état en défaut, il est configuré pour exécuter :
  ◦ Un module de détermination si la première cellule photovoltaïque appartient à une chaîne de modules dans laquelle toutes les cellules photovoltaïques sont dans l'état en défaut ou si la première cellule photovoltaïque appartient à une chaîne de modules dans laquelle au moins une cellule photovoltaïque est dans un état sain.

Selon une autre particularité :

- Si la première cellule photovoltaïque appartient à une chaîne de modules dans laquelle au moins une cellule photovoltaïque est dans un état sain, il est configuré pour exécuter :
  ◦ Un module de détermination si la première cellule photovoltaïque appartient à un sous-module qui comporte au moins une cellule dans l'état sain ou à un sous-module qui ne comporte aucune cellule à l'état sain.

Selon une autre particularité :

- Si la première cellule photovoltaïque appartient à un sous-module qui comporte au moins une cellule à l'état sain, il est configuré pour exécuter :
  ◦ Un module de comparaison de la température de la première cellule avec ladite température de référence pour déterminer si ladite température de la première cellule est supérieure à ladite température de référence ou inférieure à ladite température de référence.

Selon une autre particularité :

- Si la température de la première cellule photovoltaïque est inférieure à la température de référence, il est configuré pour exécuter une boucle de recherche de la courbe I-V associée à ladite première cellule photovoltaïque, ladite boucle de recherche comprenant :

  ◦ Une étape d'application d'une première irradiance ;
  ◦ Une étape de détermination dans la base de données de courbes I-V d'une première courbe I-V correspondant à ladite première irradiance et à ladite température de la première cellule photovoltaïque ;
  ◦ A partir de ladite première courbe, une étape de détermination de la tension qui correspond au courant au point de fonctionnement maximal ;
  ◦ Une étape de vérification de la relation suivante :

$$G = P_{th\_cell\_k} + I_{mpp} \times V(I_{mpp})$$

  Dans laquelle :

   ▪ G correspond à ladite première irradiance introduite en entrée ;
   ▪ $P_{th\_cell\_k}$ correspond à la puissance thermique générée par ladite première cellule photovoltaïque ;
   ▪ $I_{mpp}$ correspond au courant au point de fonctionnement maximal ;
   ▪ $V(I_{mpp})$ correspond à la tension déterminée sur ladite première courbe I-V pour ledit courant au point de fonctionnement maximal ;

  ◦ Si ladite relation est vérifiée, ladite courbe I-V est valide ;
  ◦ Si ladite relation n'est pas vérifiée, ladite boucle est recommencée en modifiant la valeur de l'irradiance appliquée en entrée.

Selon une autre particularité :

- Si la température de la première cellule photovoltaïque est supérieure à la température de référence, il est configuré pour exécuter :

  ◦ Un module de détermination de la tension de la première cellule photovoltaïque en défaut à partir de la relation suivante :

$$V_{cell\_k} = V_{mpp} - \Delta P_{th\_cell\_k}/I_{mpp}$$

  Dans laquelle :

   ▪ $V_{cell\_k}$ correspond à la tension de la première cellule photovoltaïque ;
   ▪ $V_{mpp}$ correspond à la tension au point de fonctionnement maximal ;
   ▪ $\Delta P_{th\_cell\_k}$ correspond aux pertes énergétiques occasionnés par la première cellule photovoltaïque en défaut ;
   ▪ $I_{mpp}$ correspond au courant au point de fonctionnement maximal ;

  ◦ Un module de recherche dans la base de données de courbes I-V de la courbe I-V qui correspond à une irradiance de référence, et pour laquelle le point ayant pour coordonnées ladite tension déterminée pour la première cellule photovoltaïque et le courant au point de fonctionnement maximal appartient à la courbe.

Selon une autre particularité :

- Si la première cellule photovoltaïque appartient à un sous-module qui ne comporte aucune cellule à l'état sain, il est configuré pour exécuter :
  ◦ Un module de détermination si toutes les cellules de son sous-module présentent une puissance électrique nulle ou si au moins une cellule dudit sous-module présente une puissance électrique non-nulle.

Selon une autre particularité :

- Si toutes les cellules de son sous-module présentent une puissance électrique nulle, il est configuré pour exécuter :
  ◦ Un module d'estimation de la courbe I-V associée à ladite première cellule photovoltaïque par recherche dans une base de données de courbes I-V d'une courbe I-V définie par {(*I,V*) *tel que I* $\geq$ 0 *et V* = 0} et {(*I,V*) *tel que I* = 0 *et V* $\geq$ 0} ;

Selon une autre particularité :

- Si au moins une cellule dudit sous-module présente une puissance électrique non nulle, il est configuré pour mettre en œuvre une boucle de recherche de la courbe I-V associée à ladite première cellule photovoltaïque, ladite boucle de recherche comprenant :

  ◦ Une étape d'application d'un premier courant ;
  ◦ Une étape de détermination, pour chaque cellule photovoltaïque dudit sous-module, de la tension de la cellule à partir de la relation suivante :

$$V_{cell\_k}(I_{in}) = (P_{elec\_sain} - \Delta P_{th\_cell\_k})/I_{in}$$

  Dans laquelle :

  - $V_{cell\_k}$ correspond à la tension de la chaque cellule photovoltaïque dudit sous-module, avec k=1 à n cellules photovoltaïques dans le sous-module ;
  - $I_{in}$ correspond audit premier courant appliqué en entrée ;
  - $P_{elec\_sain}$ correspond à la puissance fournie par une cellule photovoltaïque dans un état sain ;
  - $\Delta P_{th\_cell\_k}$ correspond aux pertes énergétiques occasionnés par chaque cellule photovoltaïque en défaut ;

  ◦ Une étape de détermination de la somme des tensions de toutes les cellules photovoltaïques du sous-module ;
  ◦ Une étape de vérification si ladite somme est nulle ou non nulle ;
  ◦ Si ladite somme est nulle :
  - Une étape d'estimation de la courbe I-V associée à ladite première cellule photovoltaïque par recherche dans une base de données de courbes I-V d'une courbe I-V pour laquelle le point ayant pour coordonnées ladite tension déterminée pour la première cellule photovoltaïque et le premier courant appliqué en entrée appartient à la courbe ;
  ◦ Si ladite somme est non nulle :
  - Une étape de modification du premier courant appliqué en entrée et de nouvelle mise en œuvre de ladite boucle de recherche en tenant compte du premier courant modifié.

**Brève description des figures**

D'autres caractéristiques et avantages vont apparaître dans la description détaillée qui suit faite en regard des dessins annexés dans lesquels :

- La figure 1 représente de manière schématique une architecture photovoltaïque classique ;
- La figure 2 représente de manière schématique un module photovoltaïque, du côté de sa face avant ;
- La figure 3 représente les courbes I-V d'un module photovoltaïque pour plusieurs niveaux d'irradiance ;
- La figure 4 représente, pour un même niveau d'irradiance sur un module photovoltaïque, deux courbes I-V caractéristiques d'un dispositif photovoltaïque, respectivement sans défaut et avec un défaut ;
- La figure 5 représente de manière schématique la structure du système de caractérisation électrique de l'invention ;
- La figures 6A et 6B illustrent deux modes d'acquisition de température sur un module photovoltaïque, par capteur de température et/ou caméra thermique sur le module ;
- La figure 7 représente un diagramme illustrant un exemple d'algorithme mis en œuvre dans le cadre du procédé de l'invention pour caractériser électriquement une cellule photovoltaïque d'un module photovoltaïque ;
- La figure 8 représente un diagramme détaillant l'une des étapes du procédé de l'invention ;
- La figure 9A représente un diagramme illustrant un premier cas de fonctionnement dans le procédé de l'invention ;
- La figure 9B représente un diagramme illustrant un deuxième cas de fonctionnement dans le procédé de l'invention ;
- La figure 10 représente un diagramme illustrant un troisième cas de fonctionnement dans le procédé de l'invention ;

**Description détaillée d'au moins un mode de réalisation**

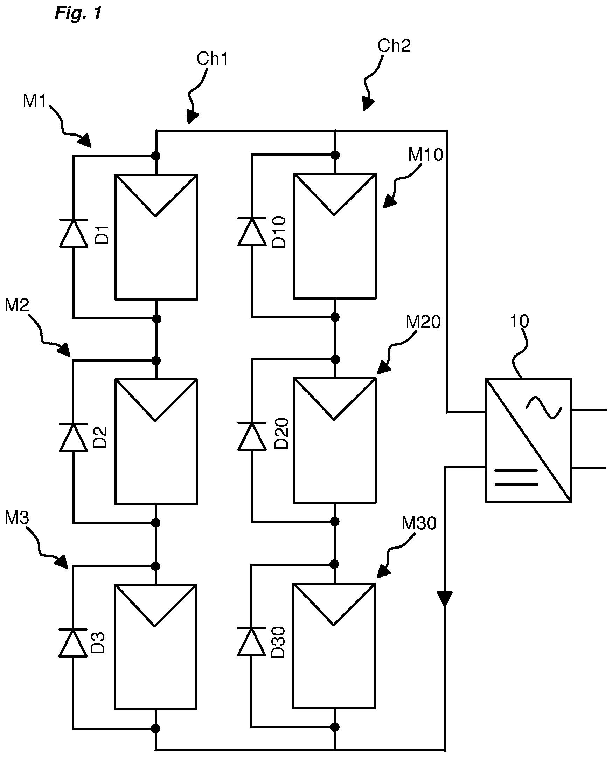

En référence à la figure 1, une architecture photovoltaïque présente classiquement les particularités d'agencement et de fonctionnement suivantes :

- Plusieurs chaînes Ch1, Ch2 de modules photovoltaïques (appelés également panneaux photovoltaïques ou panneaux solaires) sont connectées en parallèle (deux chaînes sur la figure 1).
- Chaque chaîne de modules photovoltaïques comporte plusieurs modules photovoltaïques connectés en série (M1-M3 pour la chaine Ch1 et M10-M30 pour la chaîne Ch2).
- Un module photovoltaïque (référencé de manière générale Mi dans la suite du texte) comporte plusieurs cellules photovoltaïques (non représentées sur la figure 1) connectées en série. Les cellules photovoltaïques sont réparties en plusieurs sous-modules. Un sous-module peut comporter une ou plusieurs cellules photovoltaïques.
- Chaque cellule photovoltaïque est destinée à convertir une énergie solaire en une énergie électrique.
- Un convertisseur, par exemple un onduleur 10, comportant plusieurs bras de commutation à base de transistors, est destiné à convertir une tension continue fournie par chaque chaîne de modules en une tension alternative.
- Des moyens de commande, intégrés ou non au convertisseur, sont aptes à commander l'onduleur pour effectuer la conversion de tension.
- Chaque module comporte avantageusement des diodes anti-retours (non représentées) positionnées de manière adaptée, par exemple en série avec les modules de chaque chaîne.
- Chaque module comporte avantageusement des diodes de contournement (dites de "bypass") pour contourner chacune un module et/ou un sous-module de cellules distinctes d'un module si une ou plusieurs cellules étaient en défaut. Sur la figure 1, une diode de contournement est représentée par module (les diodes sont référencées D1, D2, D3, D10, D20, D30 sur la figure 1).

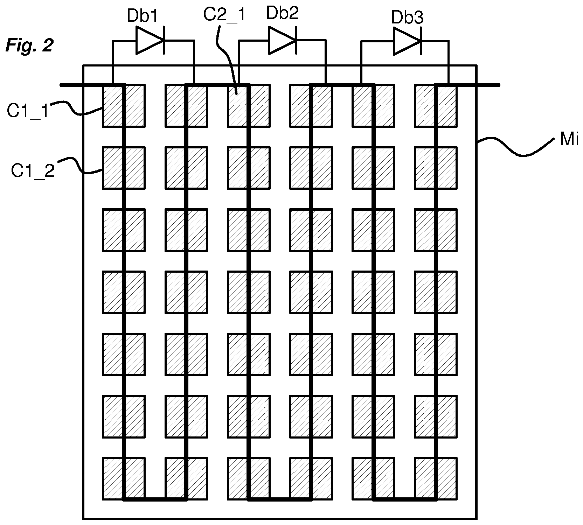

En référence à la figure 2, dans chaque module Mi, on a l'agencement suivant :

- Les cellules photovoltaïques sont organisées en plusieurs sous-modules. Sur la figure 2 deux colonnes de cellules forment un sous-module. Sur cette figure, la cellule référencée C1_1 correspond à la première cellule de la première rangée et la cellule référencée C1_2 correspond à la deuxième cellule de la première rangée. La cellule référencée C2_1 correspond à la première cellule de la deuxième rangée.
- Sur la figure 2, une diode de contournement Db1, Db2, Db3 distincte est associée à chaque sous-module représenté. Sur la figure 2, un sous-module est représenté avec plusieurs cellules mais il pourrait ne comporter qu'une seule cellule. La diode de contournement est destinée à contourner le sous-module en cas de défaillance d'une ou plusieurs cellules dans le sous-module.

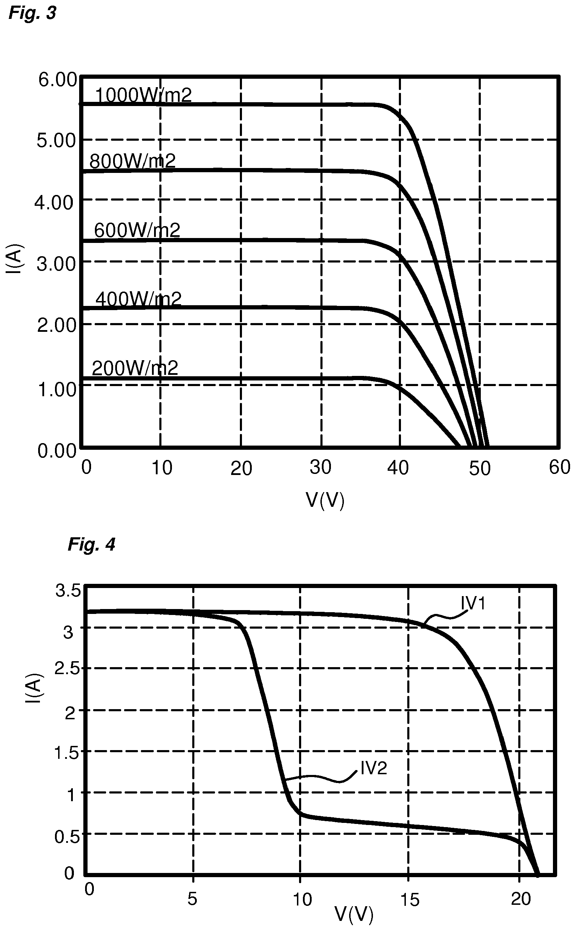

Comme évoqué précédemment, les performances d'un module photovoltaïque Mi sont caractérisées par un ensemble de courbes Courant-Tension, dénommées ci-après courbes I-V. La figure 3 représente les courbes I-V caractéristiques de référence d'un module photovoltaïque pour différents niveaux d'ensoleillement, appelés irradiance ou rayonnement et exprimés en W/m$^2$.

La tension totale d'une chaîne de modules photovoltaïques résulte de la somme des tensions aux bornes de chaque module (en incluant celles aux bornes des câbles et connectiques). Aux bornes de chaque module, les tensions pourront être différentes si les modules présentent des caractéristiques I-V distinctes. En revanche, même si les modules M1 à M3 de la chaîne Ch1 présentent des caractéristiques I-V différentes, le fonctionnement de la chaîne sera tel que le courant de la chaîne qui traverse chaque module Mi de la chaîne reste le même. Si un module est défaillant et ne peut faire passer ce courant, une ou plusieurs diodes de "bypass" (Db) permettent de faire circuler le courant supplémentaire que les cellules du module ne peuvent faire passer. Le courant total fournie par l'architecture est la somme des courants qui traversent chaque chaîne de l'architecture.

La figure 4 représente, pour un même module photovoltaïque Mi, la courbe I-V, référencée IV1, obtenue lorsque ce module est sain et la courbe I-V, référencée IV2, obtenue lorsque le module est défaillant.

On comprend ainsi l'importance de surveiller l'état de fonctionnement des modules Mi d'une architecture photovoltaïque et de mettre en place un procédé qui puisse facilement caractériser électriquement un module photovoltaïque, par sa courbe I-V, en vue de détecter un défaut.

Il existe différents types de défauts possibles sur un module photovoltaïque inclus dans une chaîne de modules. De manière non exhaustive, voici une liste de certains défauts rencontrés classiquement :

- Un module photovoltaïque plus chaud que les autres modules de la chaîne ;

- Un sous-module plus chaud que les autres sous-modules du module photovoltaïque ;

- Plusieurs cellules photovoltaïques isolées sont plus chaudes que les autres cellules du module photovoltaïque (mosaïque) ;

- Plusieurs cellules photovoltaïques situées en bas du module sont plus chaudes que les cellules photovoltaïques situées en haut du module photovoltaïque ;

- Une seule cellule photovoltaïque est plus chaude que les autres cellules photovoltaïques du module ;

- Une partie d'une cellule photovoltaïque est plus chaude que la normale ;

- Point chaud sur le module photovoltaïque ;

- Un sous-module est plus chaud que les autres sous-modules du module ;

Le principe de l'invention repose sur l'estimation de la courbe I-V de chaque cellule photovoltaïque d'un module photovoltaïque, en se basant presque uniquement sur la température de la cellule photovoltaïque. Un système de caractérisation électrique de chaque cellule photovoltaïque est ainsi implémenté.

Le procédé de caractérisation électrique de chaque cellule photovoltaïque d'un module photovoltaïque est mis en œuvre en suivant plusieurs étapes successives. On verra que certaines de ces étapes doivent être mises en œuvre préalablement à d'autres.

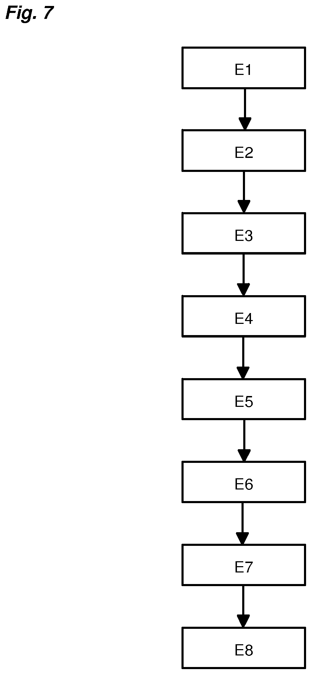

De manière non limitative, ces étapes, au nombre de 8, sont décrites ci-dessous en liaison avec la figure 7. Pour la mise en œuvre de chacune des étapes, un système de caractérisation électrique est employé. Ce système comporte une unité de traitement 3. L'unité de traitement comporte au moins un microprocesseur 30, des moyens de mémorisation. Elle comporte également un module de communication 31 lui permettant de communiquer, via des liaisons filaires et/ou sans fils avec des organes externes de type capteur. Elle comporte également d'autres moyens ou modules qui seront décrits ci-après pour la mise en œuvre de chaque étape.

Le principe de l'invention repose également sur l'emploi d'une base de données D_IV stockant des courbes I-V. Des mesures en laboratoire (type "flash test") permettent de déterminer des courbes I-V pour différents niveaux d'irradiance et de température. Par ailleurs les fiches constructeurs ("datasheets") peuvent permettre de compléter et d'affiner les résultats obtenus en laboratoire. Des moyens de mémorisation (type serveur distant ou local par exemple) permettent de stocker un ensemble de courbes I-V basées sur ces tests. Dans la base de données, chaque courbe I-V est associée à une valeur d'irradiance et à une température de la zone photovoltaïque irradiée. Pour déterminer la courbe I-V d'une cellule photovoltaïque en défaut, il conviendra cependant de distinguer plusieurs cas de fonctionnement. Ces différents cas de fonctionnement seront explicités ci-après. De manière non limitative, on considérera que la base de données D_IV est stockée dans les moyens de mémorisation de l'unité de traitement 3.

Pour la description des étapes ci-dessous, on considérera une architecture photovoltaïque qui comporte :

- Une chaîne de modules photovoltaïques ;

- La chaîne de modules photovoltaïques comporte au moins deux modules photovoltaïques ;

- Chaque module photovoltaïque comporte plusieurs cellules photovoltaïques ;

- Dans chaque module, les cellules photovoltaïques sont organisées en plusieurs sous-modules, un sous-module comportant une ou plusieurs cellules photovoltaïques contournées par au moins une diode de contournement ;

**Etape E1** - **Mesure de la température de chaque cellule photovoltaïque au sein de chaque module photovoltaïque**

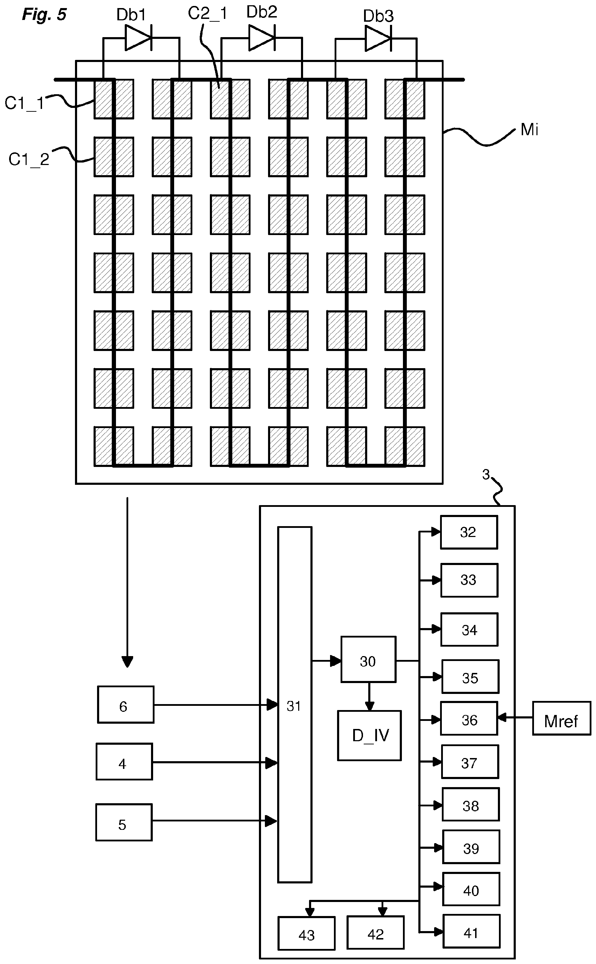

En référence à la figure 5, le système de caractérisation électrique comporte des moyens d'acquisition 6 de données représentatives de valeurs de températures au niveau du module photovoltaïque en fonctionnement.

Les moyens d'acquisition employés sont connectés à l'unité de traitement 3, via son module de communication 31, pour envoyer lesdites données de température (l'image Img ou les températures en provenance des capteurs). Toute solution de connexion de type filaire ou sans-fil peut être envisagée.

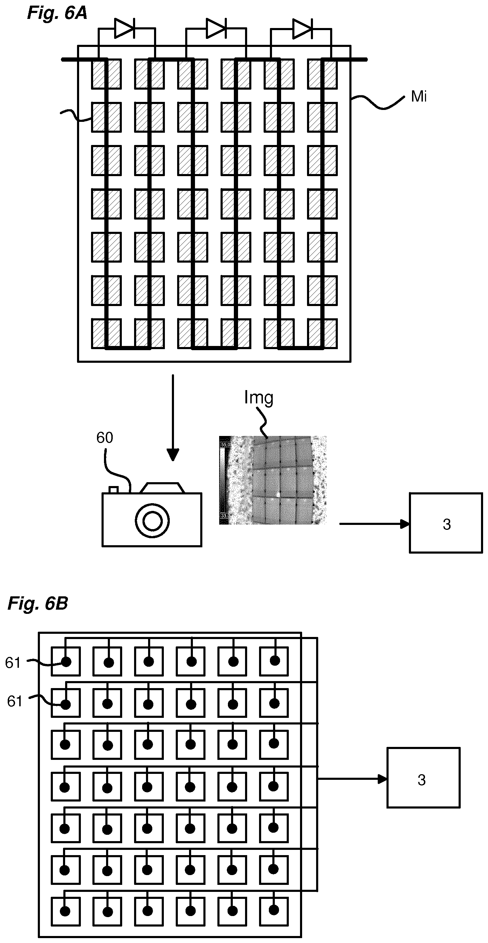

En référence à la figure 6A, ces moyens d'acquisition peuvent être une caméra thermique 60 destinée à prendre une image thermique Img de la surface du module photovoltaïque surveillé.

La caméra thermique 60 peut être associée à l'unité de traitement 3 dans un même boîtier.

Sur la figure 6A, une caméra thermique est représentée et fournit une image Img thermique du module à l'unité centrale 3. La caméra peut être portée par un opérateur ou installée sur un drone destiné à survoler l'installation photovoltaïque.

En référence à la figure 6B, les moyens d'acquisition 6 peuvent être des dispositifs 61 de mesure de température répartis au niveau de chaque cellule ou d'un ensemble de cellules photovoltaïques du module surveillé et positionnés de manière adaptée.

Un dispositif de mesure de température peut comporter :

- Un capteur de température analogique ou numérique positionné au plus près de la cellule ;

- Des moyens de conversion analogique/numérique pour convertir le signal analogique fourni par le capteur si celui-ci est analogique ;

- Une interface de communication agencée pour transmettre les données de mesure vers une unité de traitement ;

- Un module d'alimentation électrique pour alimenter le dispositif ;

Les moyens de conversion, l'interface de communication et le module d'alimentation pourront être communs à plusieurs dispositifs.

Les différents composants des dispositifs de mesure de température pourront être organisés selon plusieurs configurations. Chaque capteur de température est localisé au plus près d'une cellule de manière à capter précisément la température de la cellule, alors que les autres composants du dispositif peuvent être déportés par rapport au capteur.

De manière non limitative, chaque capteur de température peut être agencé selon différentes configurations :

- Il peut être fixé sur la face arrière de la cellule (comme sur la figure 6B), ou

- Il peut être encapsulé dans le module de manière à être positionné entre des cellules et pris entre les deux faces d'un module.

De manière non limitative, chaque capteur de température se présentera par exemple sous la forme d'un thermomètre à résistance de platine (RTD) PT100 ayant une précision d'au moins 0.1°C sur une plage de température allant de 0°C à 100°C.

Les mesures de température au niveau de plusieurs cellules d'un module sont avantageusement synchronisées entre elles. Pour cela, toute méthode de synchronisation connue pourra être employée. Celle-ci sera mise en œuvre par l'unité de traitement UC du système.

Toute autre solution de mesure ou d'acquisition des températures des cellules pourrait être employée.

L'unité de traitement 3 peut comporter un module de découpage 32 ou de décomposition d'une image thermique Img reçue d'une caméra thermique 60. Ce module est exécuté sur demande par le microprocesseur 30 lorsqu'une image thermique a été acquise en provenance de la caméra thermique.

Le découpage peut consister à décomposer l'image thermique en plusieurs zones. Il est réalisé par un traitement d'image mis en œuvre par l'unité de traitement. Chaque zone de température est caractérisée par une température propre qui est uniforme ou quasi-uniforme sur toute la zone. Deux zones thermiques adjacentes présentent entre elles un écart de température suffisant, par exemple supérieur à un certain seuil (par exemple 10°C). Par quasi-uniforme, on veut dire que la température peut varier d'un point à un autre de la zone thermique, mais que la différence de température entre deux points d'une même zone reste toujours inférieure audit seuil. A chaque zone thermique est ensuite associée une température déterminée représentative de la température de la zone. Cette température affectée à chaque zone peut être une température moyenne déterminée à partir de toutes les températures de la zone.

Le même découpage en plusieurs zones thermiques peut bien entendu être réalisé à l'aide des données fournies par les capteurs de température.

L'unité de traitement 3 peut comporter un module de détermination 33 des surfaces respectives des différentes zones thermiques découpées.

L'unité de traitement 3 peut comporter un module de détermination 34 d'une matrice de températures, la matrice de températures consistant, après découpage du module surveillé en plusieurs zones, à affecter une température à chaque zone. Cette matrice est obtenue quels que soient les moyens d'acquisition employés. Dans le cas où des dispositifs de mesure de température sont employés, la création de la matrice de température consiste à affecter directement à chaque cellule leur température mesurée respective. La matrice est mise à jour régulièrement, par exemple de manière périodique, pour surveiller l'évolution de la température de chaque cellule photovoltaïque.

**Etape E2 - Analyse des températures acquises pour identification de l'état de chaque cellule photovoltaïque**

L'unité de traitement 3 peut comporter un module de détection 35 de l'état de chaque cellule photovoltaïque du module entre un état sain ou un état en défaut.

Une cellule photovoltaïque sera considérée dans un état sain lorsque sa température est sensiblement égale à une température dite de référence. La température d'une cellule dans un état sain sera notée $T_{sain}$.

On aura ainsi :

$$T_{sain} = T_{ref}$$

Une cellule photovoltaïque sera considérée dans un état en défaut lorsque sa température dépasse un certain seuil. Ce seuil sera par exemple égal à la température de référence à laquelle est ajouté un delta de température.

La température $T_{cell\_k}$ d'une cellule k en défaut sera ainsi définie par :

$$T_{cell\_k} > T_{ref} + \Delta T$$

Avec $\Delta T$ qui correspond à un écart de température qui est supérieure à une valeur minimale $\Delta T_{min}$ (par exemple égale à 2°C).

L'unité de traitement 3 peut comporter un module d'obtention 36 de la température de référence Tref à partir d'un module désigné comme module de référence Mref.

La température de référence Tref est la température d'un module de référence Mref considéré comme sain, c'est-à-dire sans défaut en fonctionnement. Le module de référence Mref est un module photovoltaïque analogue au module photovoltaïque surveillé (c'est-à-dire avec les mêmes caractéristiques techniques) mais non défectueux. Il est avantageusement présent dans la même architecture photovoltaïque que le module surveillé. La température de référence peut être obtenue d'une manière identique à celle utilisée pour le module surveillé, c'est -à-dire à partir d'une image thermique du module et/ou de dispositifs de mesure de température. Les données de température du module de référence peuvent être envoyées à l'unité de traitement 3 qui peut alors calculer la température de référence à l'aide du module 36 adapté. Cette température de référence Tref peut correspondre à la température moyenne du module de référence Mref.

**Etape E3 - Estimation des pertes thermiques supplémentaires occasionnées par chaque cellule photovoltaïque en défaut**

L'unité de traitement 3 peut comporter un module 37 d'estimation des pertes thermiques supplémentaires d'un module, occasionnées par la présence d'une cellule en défaut dans le module.

Pour une cellule, ces pertes thermiques s'expriment par la relation suivante :

$$\Delta P_{th\_cell-k} = U_{pv} \times (T_{cell\_k} - T_{sain})$$

Dans laquelle :

- $\Delta P_{th_{cell\_k}}$ correspond aux pertes thermiques supplémentaires créées ;
- $U_{pv}$ représente le coefficient d'échange thermique du module ;
- $T_{cell\_k}$ correspond à la température de la cellule en défaut ;
- $T_{sain}$ correspond à la température d'une cellule saine ;

Cette relation est notamment détaillée dans la demande de brevet WO2016/189052A1, incorporée ici par référence.

**Etape E4 - Calcul du rayonnement reçu dans le plan de chaque module photovoltaïque**

De manière optionnelle, le système peut comporter un dispositif de mesure 5 de l'irradiance. Ce dispositif est alors configuré pour communiquer avec l'unité de traitement, via le module de communication 31.

En remplacement ou en complément, l'unité de traitement 3 peut comporter un module 38 de détermination de l'irradiance reçue par le module. Ce module peut se baser sur une ou plusieurs des méthodes suivantes ou sur toute autre méthode possible :

- Mesure à l'aide d'un dispositif de mesure d'irradiance 5 présent sur le site de l'installation photovoltaïque ;
- Récupération de données diverses telles que position géographique de l'installation, orientation et inclinaison des modules, de l'environnement, de la date, de l'heure, de données météorologiques ;
- Récupération de données satellites ;
  L'irradiance déterminée par l'une de ces méthodes est notée ci-après $G_{sain}$.

**Etape E5 - Estimation de la courbe I-V de chaque cellule saine**

L'unité de traitement 3 comporte un module 39 d'estimation de la courbe I-V de chaque cellule saine d'un module photovoltaïque. Lors de son exécution, ce module 39 s'appuie sur la base de données de courbes I-V disponibles.

Chacune des cellules photovoltaïques ayant été déclarées dans un état sain par le module de détection 35 ont une température égale à $T_{sain}$. En outre, elles subissent donc forcément un rayonnement égal à $G_{sain}$.

Connaissant $T_{sain}$ et $G_{sain}$, le module 39 d'estimation cherche dans la base de données des courbes I-V, la courbe I-V correspondante à ces conditions de fonctionnement.

Partant de cette courbe I-V, un module 40 spécifique de l'unité de traitement 3 peut identifier les valeurs du courant $I_{mpp}$ et $V_{mpp}$. Ces valeurs sont utiles au module d'estimation de la température ambiante pour déterminer la valeur de la température ambiante $T_a$ selon le raisonnement décrit ci-après.

**Etape E6 - Estimation de la température ambiante**

Le système peut comporter un dispositif de mesure 4 de la température ambiante qui est connecté à l'unité de traitement 3, via le module de communication 31.

En remplacement ou en complément, l'unité de traitement 3 peut comporter un module 41 d'estimation de la température ambiante (par exemple si le capteur de température ambiante est absent). Ce module applique la méthode suivante :

On a:

$$P_{elec\_sain} = I_{mpp} \times V_{mpp}$$

$$G_{sain} = P_{th\_sain} + P_{elec\_sain}$$

$$P_{th\_sain} = U_{th} \times (T_{sain} - T_a)$$

On obtient alors :

$$T_a = T_{sain} - \frac{(G_{sain} - P_{elec\_sain})}{U_{th}}$$

Avec :

- $P_{elec\_sain}$ qui correspond à la puissance électrique fournie par une cellule saine ;
- $I_{mpp}$ qui correspond au courant au point de fonctionnement maximal ("Maximum Power Point") ;
- $V_{mpp}$ qui correspond à la tension au point de fonctionnement maximal ;
- $P_{th\_sain}$ qui correspond à la puissance thermique dégagée par une cellule saine ;
- $T_{sain}$ qui correspond à la température d'une cellule saine ;
- $T_a$ qui correspond à la température ambiante recherchée ;
- $G_{sain}$ qui représente l'irradiance reçue par le module, c'est-à-dire la puissance du flux lumineux irradiant le module photovoltaïque de référence (donc le module sain) ;

**Etape E7** - **Estimation de la puissance thermique dissipée par chaque cellule photovoltaïque en défaut**

L'unité de traitement 3 peut comporter un module 42 d'estimation de la puissance thermique dissipée par chaque cellule en défaut. Cette puissance s'exprime par la relation suivante :

$$P_{th\_cell\_k} = U_{th} \times (T_{cell\_k} - T_a)$$

Dans laquelle :

- $P_{th\_cell\_k}$ correspond à la puissance thermique dissipée par une cellule k en défaut du module ;
- $U_{th}$ correspond au coefficient d'échange thermique du module ;
- $T_a$ correspond à la température ambiante ;

**Etape E8** - **Estimation de la courbe I-V de chaque cellule photovoltaïque en défaut**

L'unité de traitement 3 comporte un module 43 d'estimation de la courbe I-V de chaque cellule k en défaut d'un module photovoltaïque.

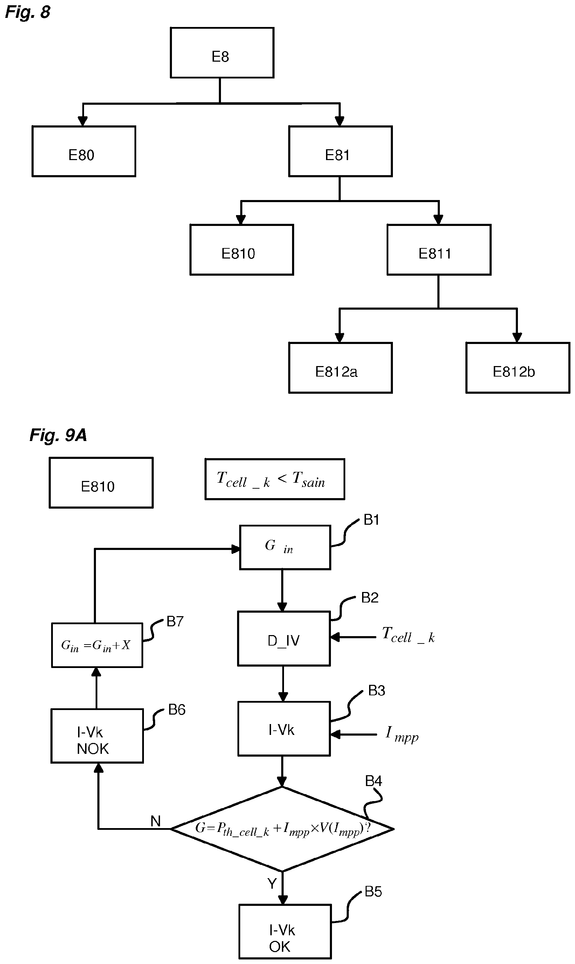

Ce module 43 d'estimation applique l'algorithme décrit ci-dessous. Cet algorithme consiste à définir la situation en tenant compte de l'état des différentes cellules et de la situation de chaque cellule en défaut au sein de la chaîne de modules et au sein de son sous-module. Les figures 8 à 10 illustrent précisément les différentes étapes mises en œuvre et les différents cas de fonctionnement à prendre en compte.

Le module 43 d'estimation applique un premier module de test pour vérifier si la chaîne de modules photovoltaïques est entièrement en défaut, c'est-à-dire qu'elle ne comporte aucune cellule photovoltaïque dont la température est égale à $T_{sain}$ (étape E80) ou si la chaîne n'est pas entièrement en défaut et qu'elle comporte au moins une cellule saine, dont la température est égale à $T_{sain}$ (étape E81).

**A. Premier cas de fonctionnement** - **E80**

Dans ce premier cas de fonctionnement, la chaîne de modules photovoltaïques surveillé ne comporte aucune cellule photovoltaïque saine, c'est-à-dire aucune cellule photovoltaïque dont la température est égale à $T_{sain}$.

Ce cas s'explique par un défaut de connexion de la chaîne de modules photovoltaïques à l'onduleur ou par un défaut franc de court-circuit ou de type circuit ouvert (par exemple au niveau de la connexion entre deux modules).

Dans ce cas, chaque cellule photovoltaïque du module photovoltaïque peut être caractérisée par une courbe I-V équivalente à celle d'une cellule saine car les cellules ne sont pas directement en cause.

**B. Deuxième cas de fonctionnement** - **E81**

Dans ce deuxième cas de fonctionnement, la chaîne de modules photovoltaïques comporte au moins une cellule k en défaut et au moins une cellule photovoltaïque saine, c'est-à-dire dont la température est égale à $T_{sain}$.

Ce deuxième cas de fonctionnement peut se diviser en deux-sous cas de fonctionnement :

a) Un premier sous-cas de fonctionnement (E810) dans lequel la cellule photovoltaïque k en défaut est accompagnée dans son sous-module d'au moins une cellule photovoltaïque saine dont la température est égale à $T_{sain}$.

b) Un deuxième sous-cas de fonctionnement (E811) dans lequel la cellule photovoltaïque k en défaut n'est accompagnée dans son sous-module d'aucune cellule photovoltaïque saine, c'est-à-dire d'aucune cellule photovoltaïque dont la température est égale à $T_{sain}$.

a) Dans le premier sous-cas de fonctionnement (E810), pour la cellule k qui est en défaut dans le sous-module et dont la température $T_{cell\_k}$ est différente de $T_{sain}$, on a :

- Le courant $I_{cell\_k}$ qui traverse la cellule k est identique à $I_{mpp}$ puisque les cellules photovoltaïques sont en série dans le sous-module ;
- En référence à la figure 9A, si $T_{cell\_k} < T_{sain}$, on peut en conclure que :

    ◦ La cellule photovoltaïque k est ombrée et est donc à une irradiance $G_{cell\_k}$ ;
    ◦ La puissance thermique dissipée par la cellule k en défaut vaut alors :

$$P_{th\_cell\_k} = G_{cell\_k} - I_{mpp} \times V_{cell\_k}$$

Avec :

- $P_{th\_cell\_k}$ qui est la puissance thermique fournie par la cellule k en défaut, cette valeur étant connue de la relation définie ci-dessus à l'étape 7 : $P_{th\_cell\_k} = U_{th} \times (T_{cell\_k} - T_a)$ ;
- $I_{mpp}$ qui est le courant au point de fonctionnement maximal ("Maximum Power Point") qui est également connu par la mise en œuvre de l'étape 5 ci-dessus.

○ Il s'agit alors de mettre en œuvre une boucle de reconnaissance telle que représentée sur la figure 9A. La boucle consiste à :

○ Faire prendre à l'irradiance G une valeur (notée $G_{in}$) entre 0 et $G_{sain}$ (bloc B1) ;
○ Chercher dans la base de données D_IV des courbes I-V, la courbe qui correspond à la valeur de $G_{in}$ choisie en entrée et à la valeur de $T_{cell\_k}$ connue (bloc B2) ;
○ Trouver la courbe I-V recherchée (bloc B3) dans la base de données D_IV ;
○ A partir de la courbe sélectionnée, il s'agit d'en déduire la valeur de $V$ qui correspond à la valeur de $I_{mpp}$ connue ;
○ Enfin il s'agit de vérifier si les données de $G_{in}$ et $V$ permettent de vérifier la relation suivante (bloc B4) :

$$G = G_{cell\_k} = P_{th\_cell\_k} + I_{mpp} \times V(I_{mpp})$$

Avec $P_{th\_cell\_k}$ et $I_{mpp}$ qui sont par ailleurs connus ;
○ Si la relation est vérifiée (branche Y), la courbe I-V qui a été sélectionnée est retenue (bloc B5) ;
○ Si la relation n'est pas vérifiée (Branche N), la courbe sélectionnée dans la base de données D_IV n'est pas correcte (bloc B6) et la boucle est recommencée en partant d'une nouvelle valeur $G_{in}$ attribuée à G (Bloc B7). La boucle est stoppée lorsque la relation ci-dessus est vérifiée.

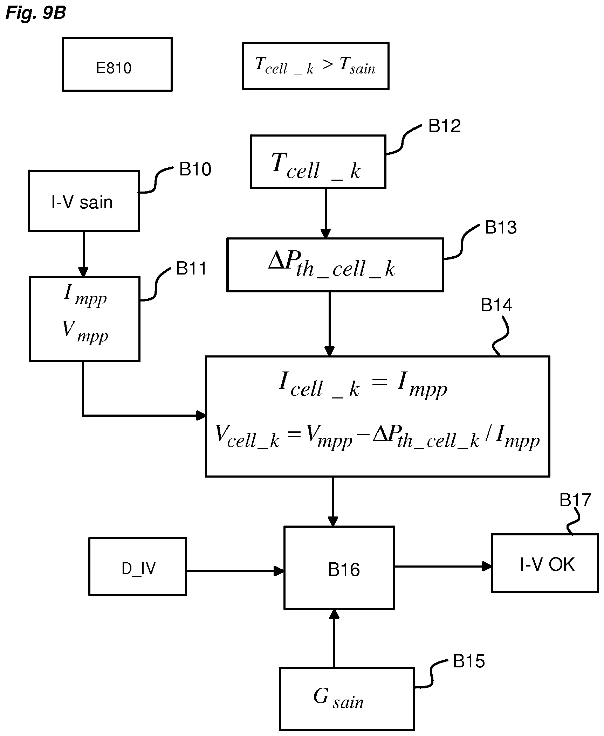

- En référence à la figure 9B, si $T_{cell\_k} > T_{sain}$, on peut en conclure que :

○ Pour chaque cellule saine présente dans le sous-module, la courbe I-V correspond à la courbe pour laquelle la température est égale à $T_{sain}$ et pour laquelle l'irradiance est égale à $G_{sain}$ (Bloc B10) ;
○ A partir de la courbe I-V d'une cellule saine dans le sous-module, il est possible d'en déduire directement $I_{mpp}$ et $V_{mpp}$ (bloc B11) ;
○ La cellule k en défaut est à la température $T_{cell\_k}$ (bloc B12) ;
○ Les pertes thermiques supplémentaires engendrées par cette cellule k en défaut sont déterminées à l'étape E3 décrite ci-dessus et s'expriment par la relation (bloc B13) :

$$\Delta P_{th\_cell\_k} = U_{pv} \times (T_{cell\_k} - T_{sain})$$

○ A partir des données ci-dessus, la tension de la cellule k en défaut vaut : $V_{cell\_k} = V_{mpp} - \Delta P_{th\_cell\_k}/I_{mpp}$ (bloc B14) ;
○ La cellule photovoltaïque reçoit un rayonnement $G_{cell\_k} = G_{sain}$ identique à celui de la cellule saine (Bloc B15) ;
○ Le module 43 d'estimation recherche (bloc B16) dans la base de données D_IV de courbes I-V la courbe correspondante (bloc B16) ;
○ La courbe I-V de la cellule k en défaut est donc la courbe présente dans la base de données pour laquelle la température $T = T_{cell\_k}$ et pour laquelle le point défini par $I_{cell\_k}$ et $V_{cell\_k}$ appartient à la courbe (bloc B17) ;

b) Dans le deuxième sous-cas de fonctionnement (E811), le sous-module ne comporte aucune cellule photovoltaïque saine, c'est-à-dire aucune cellule dont la température est égale à $T_{sain}$. Le module 43 d'estimation dispose cependant des informations suivantes :

- Si la cellule était saine, sa courbe I-V correspondrait à la courbe pour laquelle la température est égale à $T_{sain}$ et pour laquelle l'irradiance est égale à $G_{sain}$ (Bloc B100) ;
- A partir de la courbe I-V d'une cellule saine, il est possible d'en déduire directement $I_{mpp}$ et $V_{mpp}$ (bloc B101) ;
- La cellule k en défaut est à la température $T_{cell\_k}$ (bloc B102) ;
- Chaque cellule k en défaut génère alors des pertes thermiques selon la relation (bloc B103) :

$$\Delta P_{th\_cell\_k} = U_{pv} \times (T_{cell\_k} - T_{sain})$$

- La tension totale du sous-module est nulle, c'est-à-dire $\sum_1^n V_{cell\_k} = 0$ car la diode de contournement du sous-module a été activée ;
- Les cellules photovoltaïques du sous-module sont traversées par un courant identique ;
- Chaque point de fonctionnement défini par $I_{cell\_k}$ et $V_{cell\_k}$ se trouve sur une courbe I-V telle que (bloc B104) :

  ◦ $I_k(V) = (P_{elec\_sain} - \Delta P_{th\_cell\_k})/V$ ou $V_k(I) = (P_{elec\_sain} - \Delta P_{th\_cell\_k})/I$
  ◦ Pour une cellule donnée, si $P_{elec} = P_{elec\_sain} - \Delta P_{th_{cell_k}} = 0$, c'est-à-dire que la cellule photovoltaïque est en court-circuit ou en circuit ouvert, alors sa courbe I-V correspond à l'ensemble des points situés sur les deux demi-axes $\{(I, V)\ tel\ que\ I \geq 0\ et\ V = 0\}$ et $\{(I, V)\ tel\ que\ I = 0\ et\ V \geq 0\}$ ;

Cependant, deux cas (E812a, E812b) distincts peuvent alors être identifiés :

1) Dans le premier cas (E812a), toutes les cellules du sous-module fournissent chacune une puissance électrique nulle, c'est-à-dire que :

$$P_{elec} = P_{elec\_sain} - \Delta P_{th\_cell\_k} = 0$$

- A l'échelle de chaque cellule photovoltaïque, chaque cellule est sans doute saine et présente donc une courbe I-V équivalente à celle d'une cellule saine.
- A l'échelle du sous-module, la courbe I-V est définie comme l'ensemble des points situés sur les deux demi-axes $\{(I, V)\ tel\ que\ I \geq 0\ et\ V = 0\}$ et $\{(I, V)\ tel\ que\ I = 0\ et\ V \geq 0\}$ ;

2) Dans le deuxième cas (E812b), au moins une cellule photovoltaïque du sous-module fournit une puissance électrique non nulle, c'est-à-dire que, pour cette cellule, on a :

$$P_{elec} = P_{elec\_sain} - \Delta P_{th_{cell_k}} \neq 0$$

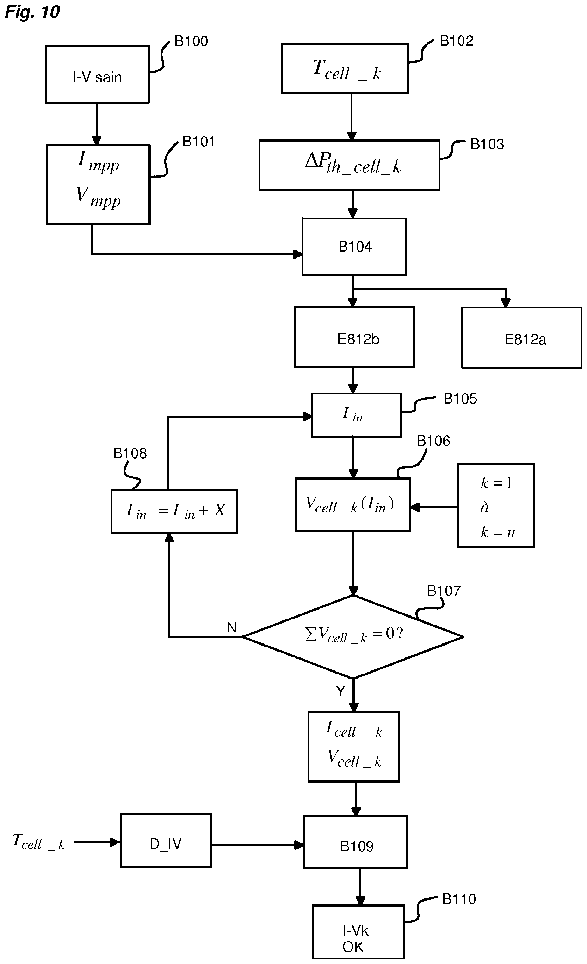

Dans cette situation, en référence à la figure 10, le module d'estimation met en œuvre la boucle suivante :

- Il fixe une même valeur de courant $I_{in}$ (bloc B105) pour toutes les cellules en défaut du sous-module (le courant étant identique dans toutes ces cellules) ;
- Il détermine pour chaque cellule k en défaut du sous-module une valeur de tension $V_{cell\_k}$ correspondante à partir de la relation $V_{cell\_k}(I_{in}) = (P_{sain} - \Delta P_{th\_cell\_k})/I_{in}$
- Pour les n cellules k du sous-module (avec k allant de 1 à n), il obtient une valeur particulière de tension $V_{cell\_k}$ (bloc B106) ;
- Il vérifie ensuite si $\sum_1^n V_{cell\_k} = 0$ (bloc B107) ;
- Si la relation n'est pas vérifiée (branche N), il recommence la boucle en modifiant la valeur du courant $I_{in}$ appliqué en entrée (bloc B108). Le courant est par exemple choisi dans une plage allant de $I_{mpp}$ (pour une cellule saine) à 0.
- Si la relation est vérifiée (branche Y), il recherche (bloc B109), dans la base de données D_IV de courbes I-V, pour chaque cellule k en défaut dans le sous-module, la courbe qui correspond à la température $T_{cell\_k}$ et à laquelle appartient le point de coordonnées $(I_{cell\_k}; V_{cell\_k})$ qui a été déterminé ;
- La courbe I-V est alors obtenue pour chaque cellule k en défaut dans le sous-module (bloc B110) ;

A partir de l'algorithme complet développé ci-dessus, l'unité de traitement 3 est à même d'estimer la courbe I-V d'une cellule photovoltaïque en défaut dans un module photovoltaïque, simplement à partir d'une mesure de sa température et en se référant à la base de données de courbes I-V.

La solution de l'invention est donc particulièrement simple à mettre en œuvre, fiable et peu couteuse. La base de données D-Iv est très souvent déjà disponible et pourra facilement être exploitée.

## Revendications

1. Procédé de caractérisation électrique d'une cellule photovoltaïque d'un module photovoltaïque (Mi), ledit module photovoltaïque comportant plusieurs cellules photovoltaïques connectées entre elles et une ou plusieurs diodes de contournement, chaque diode de contournement étant configurée pour contourner un sous-module formé d'une ou plusieurs cellules photovoltaïques dudit module photovoltaïque, comportant des étapes de :

   - Obtention de l'irradiance reçue par ledit module photovoltaïque,
   - Obtention d'une température de chaque cellule photovoltaïque d'un premier sous-module dudit module photovoltaïque,
   - Comparaison de ladite température obtenue pour chaque cellule photovoltaïque du premier sous-module avec une température de référence (Tref),
   - Détermination de l'état de chaque cellule photovoltaïque du premier sous-module entre un état sain pour lequel sa température est égale à la température de référence et un état en défaut pour lequel sa température est différente de ladite température de référence,
   - Estimation de la courbe I-V associée à une première cellule photovoltaïque dudit premier sous-module, par recherche dans une base de données de courbes I-V, en tenant compte de :

     ◦ L'état sain ou de l'état en défaut de ladite première cellule photovoltaïque ;
     ◦ L'état sain ou de l'état en défaut de toutes les autres cellules photovoltaïques du premier sous-module ;
     ◦ La puissance électrique fournie par chaque cellule photovoltaïque du premier sous-module.

2. Procédé selon la revendication 1, **caractérisé en ce que** :

   - Si la première cellule photovoltaïque est dans ledit état en défaut, il comporte une étape de :
   ◦ Détermination si la première cellule photovoltaïque appartient à une chaîne de modules dans laquelle toutes les cellules photovoltaïques sont dans l'état en défaut ou si la première cellule photovoltaïque appartient à une chaîne de modules dans laquelle au moins une cellule photovoltaïque est dans un état sain.

3. Procédé selon la revendication 2, **caractérisé en ce que** :

   - Si la première cellule photovoltaïque appartient à une chaîne de modules dans laquelle au moins une cellule photovoltaïque est dans un état sain, il comporte une étape de :
   ◦ Détermination si la première cellule photovoltaïque appartient à un sous-module qui comporte au moins une cellule dans l'état sain ou à un sous-module qui ne comporte aucune cellule à l'état sain.

4. Procédé selon la revendication 3, **caractérisé en ce que** :

   - Si la première cellule photovoltaïque appartient à un sous-module qui comporte au moins une cellule à l'état sain, il comporte une étape de :
   ◦ Comparaison de la température de la première cellule avec ladite température de référence pour déterminer si ladite température de la première cellule est supérieure à ladite température de référence ou inférieure à ladite température de référence.

5. Procédé selon la revendication 4, **caractérisé en ce que** :

   - Si la température de la première cellule photovoltaïque est inférieure à la température de référence, il consiste à mettre en œuvre une boucle de recherche de la courbe I-V associée à ladite première cellule photovoltaïque, ladite boucle de recherche comprenant :

     ◦ Une étape d'application d'une première irradiance ;
     ◦ Une étape de détermination dans la base de données de courbes I-V d'une première courbe I-V correspondant à ladite première irradiance et à ladite température de la première cellule photovoltaïque ;

◦ A partir de ladite première courbe, une étape de détermination de la tension qui correspond au courant au point de fonctionnement maximal ;

◦ Une étape de vérification de la relation suivante :

$$G = P_{th\_cell\_k} + I_{mpp} \times V(I_{mpp})$$

Dans laquelle :

- G correspond à ladite première irradiance introduite en entrée ;
- $P_{th\_cell\_k}$ correspond à la puissance thermique générée par ladite première cellule photovoltaïque ;
- $I_{mpp}$ correspond au courant au point de fonctionnement maximal ;
- $V(I_{mpp})$ correspond à la tension déterminée sur ladite première courbe I-V pour ledit courant au point de fonctionnement maximal ;

◦ Si ladite relation est vérifiée, ladite courbe I-V est valide ;

◦ Si ladite relation n'est pas vérifiée, ladite boucle est recommencée en modifiant la valeur de l'irradiance appliquée en entrée.

6. Procédé selon la revendication 4 ou 5, **caractérisé en ce que** :

- Si la température de la première cellule photovoltaïque est supérieure à la température de référence, il comporte :

◦ Une étape de détermination de la tension de la première cellule photovoltaïque en défaut à partir de la relation suivante :

$$V_{cell\_k} = V_{mpp} - \Delta P_{th\_cell\_k}/I_{mpp}$$

Dans laquelle :

- $V_{cell\_k}$ correspond à la tension de la première cellule photovoltaïque ;
- $V_{mpp}$ correspond à la tension au point de fonctionnement maximal ;
- $\Delta P_{th\_cell\_k}$ correspond aux pertes énergétiques occasionnés par la première cellule photovoltaïque en défaut ;
- $I_{mpp}$ correspond au courant au point de fonctionnement maximal ;

◦ Une étape de recherche dans la base de données de courbes I-V de la courbe I-V qui correspond à une irradiance de référence, et pour laquelle le point ayant pour coordonnées ladite tension déterminée pour la première cellule photovoltaïque et le courant au point de fonctionnement maximal appartient à la courbe.

7. Procédé selon la revendication 3, **caractérisé en ce que** :

- Si la première cellule photovoltaïque appartient à un sous-module qui ne comporte aucune cellule à l'état sain, il comporte une étape de :

◦ Détermination si toutes les cellules de son sous-module présentent une puissance électrique nulle ou si au moins une cellule dudit sous-module présente une puissance électrique non-nulle.

8. Procédé selon la revendication 7, **caractérisé en ce que** :

- Si toutes les cellules de son sous-module présentent une puissance électrique nulle, il comporte une étape de :

◦ Estimation de la courbe I-V associée à ladite première cellule photovoltaïque par recherche dans une base de données de courbes I-V d'une courbe I-V définie par {(*I,V*) *tel que I* ≥ 0 *et V* = 0} et {(*I,V*) *tel que I* = 0 *et V* ≥ 0} ;

9. Procédé selon la revendication 7 ou 8, **caractérisé en ce que** :

- Si au moins une cellule dudit sous-module présente une puissance électrique non nulle, il consiste à mettre en œuvre une boucle de recherche de la courbe I-V associée à ladite première cellule photovoltaïque, ladite boucle de recherche comprenant :

○ Une étape d'application d'un premier courant ;
○ Une étape de détermination, pour chaque cellule photovoltaïque dudit sous-module, de la tension de la cellule à partir de la relation suivante :

$$V_{cell\_k}(I_{in}) = (P_{elec\_sain} - \Delta P_{th\_cell\_k})/I_{in}$$

Dans laquelle :

- $V_{cell\_k}$ correspond à la tension de la chaque cellule photovoltaïque dudit sous-module, avec k=1 à n cellules photovoltaïques dans le sous-module ;
- $I_{in}$ correspond audit premier courant appliqué en entrée ;
- $P_{elec\_sain}$ correspond à la puissance fournie par une cellule photovoltaïque dans un état sain ;
- $\Delta P_{th\_cell\_k}$ correspond aux pertes énergétiques occasionnés par chaque cellule photovoltaïque en défaut ;

○ Une étape de détermination de la somme des tensions de toutes les cellules photovoltaïques du sous-module ;
○ Une étape de vérification si ladite somme est nulle ou non nulle ;
○ Si ladite somme est nulle :
- Une étape d'estimation de la courbe I-V associée à ladite première cellule photovoltaïque par recherche dans une base de données de courbes I-V d'une courbe I-V pour laquelle le point ayant pour coordonnées ladite tension déterminée pour la première cellule photovoltaïque et le premier courant appliqué en entrée appartient à la courbe ;
○ Si ladite somme est non nulle :
- Une étape de modification du premier courant appliqué en entrée et de nouvelle mise en œuvre de ladite boucle de recherche en tenant compte du premier courant modifié.

**10.** Système de caractérisation électrique d'une cellule photovoltaïque d'un module photovoltaïque (Mi), ledit module photovoltaïque comportant plusieurs cellules photovoltaïques connectées entre elles et une ou plusieurs diodes de contournement, chaque diode de contournement étant configurée pour contourner un sous-module formé d'une ou plusieurs cellules photovoltaïques dudit module photovoltaïque, comportant :

- Un module d'obtention de l'irradiance reçue par ledit module photovoltaïque,
- Un module d'obtention d'une température de chaque cellule photovoltaïque d'un premier sous-module dudit module photovoltaïque,
- Un module de comparaison de ladite température obtenue pour chaque cellule photovoltaïque du premier sous-module avec une température de référence (Tref),
- Un module de détermination de l'état de chaque cellule photovoltaïque du premier sous-module entre un état sain pour lequel sa température est égale à la température de référence et un état en défaut pour lequel sa température est différente de ladite température de référence,
- Un module d'estimation de la courbe I-V associée à une première cellule photovoltaïque dudit premier sous-module, par recherche dans une base de données de courbes I-V, en tenant compte de :

○ L'état sain ou de l'état en défaut de ladite première cellule photovoltaïque ;
○ L'état sain ou de l'état en défaut de toutes les autres cellules photovoltaïques du premier sous-module ;
○ La puissance électrique fournie par chaque cellule photovoltaïque du premier sous-module.

**11.** Système selon la revendication 10, **caractérisé en ce que** :

- Si la première cellule photovoltaïque est dans ledit état en défaut, il est configuré pour exécuter :
○ Un module de détermination si la première cellule photovoltaïque appartient à une chaîne de modules dans laquelle toutes les cellules photovoltaïques sont dans l'état en défaut ou si la première cellule photovoltaïque appartient à une chaîne de modules dans laquelle au moins une cellule photovoltaïque est dans un état sain.

**12.** Système selon la revendication 11, **caractérisé en ce que** :

- Si la première cellule photovoltaïque appartient à une chaîne de modules dans laquelle au moins une cellule photovoltaïque est dans un état sain, il est configuré pour exécuter :
◦ Un module de détermination si la première cellule photovoltaïque appartient à un sous-module qui comporte au moins une cellule dans l'état sain ou à un sous-module qui ne comporte aucune cellule à l'état sain.

**13.** Système selon la revendication 12, **caractérisé en ce que** :

- Si la première cellule photovoltaïque appartient à un sous-module qui comporte au moins une cellule à l'état sain, il est configuré pour exécuter :
◦ Un module de comparaison de la température de la première cellule avec ladite température de référence pour déterminer si ladite température de la première cellule est supérieure à ladite température de référence ou inférieure à ladite température de référence.

**14.** Système selon la revendication 13, **caractérisé en ce que** :

- Si la température de la première cellule photovoltaïque est inférieure à la température de référence, il est configuré pour exécuter une boucle de recherche de la courbe I-V associée à ladite première cellule photovoltaïque, ladite boucle de recherche comprenant :

◦ Une étape d'application d'une première irradiance ;
◦ Une étape de détermination dans la base de données de courbes I-V d'une première courbe I-V correspondant à ladite première irradiance et à ladite température de la première cellule photovoltaïque ;
◦ A partir de ladite première courbe, une étape de détermination de la tension qui correspond au courant au point de fonctionnement maximal ;
◦ Une étape de vérification de la relation suivante :

$$G = P_{th\_cell\_k} + I_{mpp} \times V(I_{mpp})$$

Dans laquelle :

- G correspond à ladite première irradiance introduite en entrée ;
- $P_{th\_cell\_k}$ correspond à la puissance thermique générée par ladite première cellule photovoltaïque ;
- $I_{mpp}$ correspond au courant au point de fonctionnement maximal ;
- $V(I_{mpp})$ correspond à la tension déterminée sur ladite première courbe I-V pour ledit courant au point de fonctionnement maximal ;

◦ Si ladite relation est vérifiée, ladite courbe I-V est valide ;
◦ Si ladite relation n'est pas vérifiée, ladite boucle est recommencée en modifiant la valeur de l'irradiance appliquée en entrée.

**15.** Système selon la revendication 13 ou 14, **caractérisé en ce que** :

- Si la température de la première cellule photovoltaïque est supérieure à la température de référence, il est configuré pour exécuter :

◦ Un module de détermination de la tension de la première cellule photovoltaïque en défaut à partir de la relation suivante :

$$V_{cell\_k} = V_{mpp} - \Delta P_{th\_cell\_k}/I_{mpp}$$

Dans laquelle :

- $V_{cell\_k}$ correspond à la tension de la première cellule photovoltaïque ;
- $V_{mpp}$ correspond à la tension au point de fonctionnement maximal ;
- $\Delta P_{th\_cell\_k}$ correspond aux pertes énergétiques occasionnés par la première cellule photovoltaïque en défaut ;
- $I_{mpp}$ correspond au courant au point de fonctionnement maximal ;

○ Un module de recherche dans la base de données de courbes I-V de la courbe I-V qui correspond à une irradiance de référence, et pour laquelle le point ayant pour coordonnées ladite tension déterminée pour la première cellule photovoltaïque et le courant au point de fonctionnement maximal appartient à la courbe.

**16.** Système selon la revendication 12, **caractérisé en ce que** :

- Si la première cellule photovoltaïque appartient à un sous-module qui ne comporte aucune cellule à l'état sain, il est configuré pour exécuter :
○ Un module de détermination si toutes les cellules de son sous-module présentent une puissance électrique nulle ou si au moins une cellule dudit sous-module présente une puissance électrique non-nulle.

**17.** Système selon la revendication 16, **caractérisé en ce que** :

- Si toutes les cellules de son sous-module présentent une puissance électrique nulle, il est configuré pour exécuter :
○ Un module d'estimation de la courbe I-V associée à ladite première cellule photovoltaïque par recherche dans une base de données de courbes I-V d'une courbe I-V définie par $\{(I,V)$ *tel que* $I \geq 0$ *et* $V = 0\}$ et $\{(I,V)$ *tel que* $I = 0$ *et* $V \geq 0\}$ ;

**18.** Système selon la revendication 16 ou 17, **caractérisé en ce que** :

- Si au moins une cellule dudit sous-module présente une puissance électrique non nulle, il est configuré pour mettre en œuvre une boucle de recherche de la courbe I-V associée à ladite première cellule photovoltaïque, ladite boucle de recherche comprenant :

○ Une étape d'application d'un premier courant ;
○ Une étape de détermination, pour chaque cellule photovoltaïque dudit sous-module, de la tension de la cellule à partir de la relation suivante :

$$V_{cell\_k}(I_{in}) = (P_{elec\_sain} - \Delta P_{th\_cell\_k})/I_{in}$$

Dans laquelle :

- $V_{cell\_k}$ correspond à la tension de la chaque cellule photovoltaïque dudit sous-module, avec k=1 à n cellules photovoltaïques dans le sous-module ;
- $I_{in}$ correspond audit premier courant appliqué en entrée ;
- $P_{elec\_sain}$ correspond à la puissance fournie par une cellule photovoltaïque dans un état sain ;
- $\Delta P_{th\_cell\_k}$ correspond aux pertes énergétiques occasionnés par chaque cellule photovoltaïque en défaut ;

○ Une étape de détermination de la somme des tensions de toutes les cellules photovoltaïques du sous-module ;
○ Une étape de vérification si ladite somme est nulle ou non nulle ;
○ Si ladite somme est nulle :
- Une étape d'estimation de la courbe I-V associée à ladite première cellule photovoltaïque par recherche dans une base de données de courbes I-V d'une courbe I-V pour laquelle le point ayant pour coordonnées ladite tension déterminée pour la première cellule photovoltaïque et le premier courant appliqué en entrée appartient à la courbe ;
○ Si ladite somme est non nulle :
- Une étape de modification du premier courant appliqué en entrée et de nouvelle mise en œuvre de ladite boucle de recherche en tenant compte du premier courant modifié.

**Patentansprüche**

1. Verfahren zur elektrischen Charakterisierung einer Photovoltaikzelle eines Photovoltaikmoduls (Mi), wobei das Photovoltaikmodul mehrere zusammengeschaltete Photovoltaikzellen und eine oder mehrere Bypassdioden umfasst, wobei jede Bypassdiode dazu ausgelegt ist, ein Teilmodul zu umgehen, das aus einer oder mehreren Photovoltaikzellen des Photovoltaikmoduls gebildet ist, **dadurch gekennzeichnet, dass** es die folgenden Schritte umfasst:

   - Erhalten der von dem Photovoltaikmodul empfangenen Bestrahlungsstärke,
   - Erhalten einer Temperatur jeder Photovoltaikzelle eines ersten Teilmoduls des Photovoltaikmoduls,
   - Vergleichen der für jede Photovoltaikzelle des ersten Teilmoduls erhaltenen Temperatur mit einer Referenztemperatur (Tref),
   - Bestimmen des Zustands jeder Photovoltaikzelle des ersten Teilmoduls zwischen einem gesunden Zustand, bei dem ihre Temperatur gleich der Referenztemperatur ist, und einem defekten Zustand, bei dem ihre Temperatur von der Referenztemperatur verschieden ist,
   - Schätzen der einer ersten Photovoltaikzelle des ersten Teilmoduls zugeordneten U-I-Kennlinie durch Suchen in einer U-I-Kennlinien-Datenbank unter Berücksichtigung:

      o des gesunden Zustands oder des defekten Zustands der ersten Photovoltaikzelle;
      o des gesunden Zustands oder des defekten Zustands aller übrigen Photovoltaikzellen des ersten Teilmoduls;
      o der von jeder Photovoltaikzelle des ersten Teilmoduls abgegebenen elektrischen Leistung.

2. Verfahren nach Anspruch 1, **dadurch gekennzeichnet, dass** es:

   - wenn die erste Photovoltaikzelle in dem defekten Zustand ist, den folgenden Schritt umfasst:
   o Bestimmen, ob die erste Photovoltaikzelle einem Modulstrang angehört, in dem alle Photovoltaikzelle in dem defekten Zustand sind, oder ob die Photovoltaikzelle einem Modulstrang angehört, in dem mindestens eine Photovoltaikzelle in einem gesunden Zustand ist.

3. Verfahren nach Anspruch 2, **dadurch gekennzeichnet, dass** es:

   - wenn die erste Photovoltaikzelle einem Modulstrang angehört, in dem mindestens eine Photovoltaikzelle in einem gesunden Zustand ist, den folgenden Schritt umfasst:
   o Bestimmen, ob die erste Photovoltaikzelle einem Teilmodul angehört, das mindestens eine Zelle im gesunden Zustand umfasst, oder einem Teilmodul, das keine Zelle im gesunden Zustand umfasst.

4. Verfahren nach Anspruch 3, **dadurch gekennzeichnet, dass** es:

   - wenn die erste Photovoltaikzelle einem Teilmodul angehört, das mindestens eine Zelle im gesunden Zustand umfasst, den folgenden Schritt umfasst:
   o Vergleichen der Temperatur der ersten Zelle mit der Referenztemperatur, um zu bestimmen, ob die Temperatur der ersten Zelle über der Referenztemperatur oder unter der Referenztemperatur liegt.

5. Verfahren nach Anspruch 4, **dadurch gekennzeichnet, dass** es:

   - wenn die Temperatur der ersten Photovoltaikzelle unter der Referenztemperatur liegt, darin besteht, eine Suchschleife zum Suchen der der ersten Photovoltaikzelle zugeordneten U-I-Kennlinie durchzuführen, wobei die Suchschleife umfasst:

      o einen Schritt des Ansetzens einer ersten Bestrahlungsstärke;
      o einen Schritt des Bestimmens, in der U-I-Kennlinien-Datenbank, einer ersten U-I-Kennlinie, die der ersten Bestrahlungsstärke und der Temperatur der ersten Photovoltaikzelle entspricht;
      o anhand der ersten Kennlinie, einen Schritt des Bestimmens der Spannung, die dem Strom im maximalen Arbeitspunkt entspricht;

o einen Schritt des Überprüfens der folgenden Gleichung:

$$G = P_{th\_cell\_k} + I_{mpp} \times V(I_{mpp})$$

in der:

- G der als Eingangsgröße eingegebenen ersten Bestrahlungsstärke entspricht;
- $P_{th\_cell\_k}$ der von der ersten Photovoltaikzelle erzeugten thermischen Leistung entspricht;
- $I_{mpp}$ dem Strom im maximalen Arbeitspunkt entspricht;
- $V(I_{mpp})$ der Spannung entspricht, die in der ersten U-I-Kennlinie für den Strom im maximalen Arbeitspunkt bestimmt wurde;

◦ wenn die Gleichung erfüllt ist, ist die U-I-Kennlinie gültig;
◦ wenn die Gleichung nicht erfüllt ist, wird die Schleife wiederholt, wobei der als Eingangsgröße angesetzte Wert der Bestrahlungsstärke geändert wird.

6. Verfahren nach Anspruch 4 oder 5, **dadurch gekennzeichnet, dass** es:

- wenn die Temperatur der ersten Photovoltaikzelle über der Referenztemperatur liegt, umfasst:

o einen Schritt des Bestimmens der Spannung der ersten defekten Photovoltaikzelle anhand der folgenden Gleichung:

$$V_{cell\_k} = V_{mpp} - \Delta P_{th\_cell\_k}/I_{mpp}$$

in der:

- $V_{cell\_k}$ der Spannung der ersten Photovoltaikzelle entspricht;
- $V_{mpp}$ der Spannung im maximalen Arbeitspunkt entspricht;
- $\Delta P_{th\_cell\_k}$ den energetischen Verlusten entspricht, die durch die erste defekte Photovoltaikzelle verursacht werden;
- $I_{mpp}$ dem Strom im maximalen Arbeitspunkt entspricht;

o einen Schritt des Suchens, in der U-I-Kennlinien-Datenbank, der U-I-Kennlinie, die einer Referenzbestrahlungsstärke entspricht und bei welcher der Punkt, dessen Koordinaten die für die erste Photovoltaikzelle bestimmte Spannung und der Strom im maximalen Arbeitspunkt sind, der Kennlinie angehört.

7. Verfahren nach Anspruch 3, **dadurch gekennzeichnet, dass** es:

- wenn die erste Photovoltaikzelle einem Teilmodul angehört, das keine Zelle im gesunden Zustand umfasst, den folgenden Schritt umfasst:
o Bestimmen, ob alle Zellen ihres Teilmoduls eine elektrische Leistung von null aufweisen oder ob mindestens eine Zelle des Teilmoduls eine elektrische Leistung ungleich null aufweist.

8. Verfahren nach Anspruch 7, **dadurch gekennzeichnet, dass** es:

- wenn alle Zellen ihres Teilmoduls eine elektrische Leistung von null aufweisen, den folgenden Schritt umfasst:
o Schätzen der der ersten Photovoltaikzelle zugeordneten U-I-Kennlinie durch Suchen, in einer U-I-Kennlinien-Datenbank, einer U-I-Kennlinie, die definiert ist durch {(I,V) so dass I ≥ 0 und V = 0} und {(I,V) so dass I = 0 und V ≥ 0}.

9. Verfahren nach Anspruch 7 oder 8, **dadurch gekennzeichnet, dass** es:

- wenn mindestens eine Zelle des Teilmoduls eine elektrische Leistung ungleich null aufweist, darin besteht, eine Suchschleife zum Suchen der der ersten Photovoltaikzelle zugeordneten U-I-Kennlinie durchzuführen, wobei die Suchschleife umfasst:

    o einen Schritt des Ansetzens eines ersten Stroms;
    ∘ einen Schritt des Bestimmens der Spannung der Zelle für jede Photovoltaikzelle des Teilmoduls anhand der folgenden Gleichung:

$$V_{cell\_k}(I_{in}) = (P_{elec\_sain} - \Delta P_{th\_cell\_k})/I_{in}$$

    in der:

- $V_{cell\_k}$ der Spannung jeder Photovoltaikzelle des Teilmoduls entspricht, mit k=1 bis n Photovoltaikzellen in dem Teilmodul;
- $I_{in}$ dem als Eingangsgröße angesetzten ersten Strom entspricht;
- $P_{elec\_sain}$ der von einer Photovoltaikzelle in einem gesunden Zustand abgegebenen Leistung entspricht;
- $\Delta P_{th\_cell\_k}$ den energetischen Verlusten entspricht, die durch jede defekte Photovoltaikzelle verursacht werden;

    ∘ einen Schritt des Bestimmens der Summe aus den Spannungen aller Photovoltaikzellen des Teilmoduls;
    ∘ einen Schritt des Überprüfens, ob diese Summe null oder ungleich null ist;
    ∘ wenn die Summe null ist:
- einen Schritt des Schätzens der der ersten Photovoltaikzelle zugeordneten U-I-Kennlinie durch Suchen, in einer U-I-Kennlinien-Datenbank, einer U-I-Kennlinie, bei welcher der Punkt, dessen Koordinaten die für die erste Photovoltaikzelle bestimmte Spannung und der als Eingangsgröße angesetzte erste Strom sind, der Kennlinie angehört;
    ∘ wenn die Summe ungleich null ist:
- einen Schritt des Änderns des als Eingangsgröße angesetzten ersten Stroms und des erneuten Durchführens der Suchschleife unter Berücksichtigung des geänderten ersten Stroms.

10. System zur elektrischen Charakterisierung einer Photovoltaikzelle eines Photovoltaikmoduls (Mi), wobei das Photovoltaikmodul mehrere zusammengeschaltete Photovoltaikzellen und eine oder mehrere Bypassdioden umfasst, wobei jede Bypassdiode dazu ausgelegt ist, ein Teilmodul zu umgehen, das aus einer oder mehreren Photovoltaikzellen des Photovoltaikmoduls gebildet ist, umfassend:

    - ein Modul zum Erhalten der von dem Photovoltaikmodul empfangenen Bestrahlungsstärke,
    - ein Modul zum Erhalten einer Temperatur jeder Photovoltaikzelle eines ersten Teilmoduls des Photovoltaikmoduls,
    - ein Modul zum Vergleichen der für jede Photovoltaikzelle des ersten Teilmoduls erhaltenen Temperatur mit einer Referenztemperatur (Tref),
    - ein Modul zur Bestimmen des Zustands jeder Photovoltaikzelle des ersten Teilmoduls zwischen einem gesunden Zustand, bei dem ihre Temperatur gleich der Referenztemperatur ist, und einem defekten Zustand, bei dem ihre Temperatur von der Referenztemperatur verschieden ist,
    - ein Modul zum Schätzen der einer ersten Photovoltaikzelle des ersten Teilmoduls zugeordneten U-I-Kennlinie durch Suchen in einer U-I-Kennlinien-Datenbank unter Berücksichtigung:

        o des gesunden Zustands oder des defekten Zustands der ersten Photovoltaikzelle;
        ∘ des gesunden Zustands oder des defekten Zustands aller übrigen Photovoltaikzellen des ersten Teilmoduls;
        ∘ der von jeder Photovoltaikzelle des ersten Teilmoduls abgegebenen elektrischen Leistung.

11. System nach Anspruch 10, **dadurch gekennzeichnet, dass** es:

    - wenn die erste Photovoltaikzelle in dem defekten Zustand ist, dazu ausgelegt ist, auszuführen:
    ∘ ein Modul zum Bestimmen, ob die erste Photovoltaikzelle einem Modulstrang angehört, in dem alle Photovoltaikzelle in dem defekten Zustand sind, oder ob die Photovoltaikzelle einem Modulstrang angehört, in dem mindestens eine Photovoltaikzelle in einem gesunden Zustand ist.

**12.** System nach Anspruch 11, **dadurch gekennzeichnet, dass** es:

- wenn die erste Photovoltaikzelle einem Modulstrang angehört, in dem mindestens eine Photovoltaikzelle in einem gesunden Zustand ist, dazu ausgelegt ist, auszuführen:
  ◦ ein Modul zum Bestimmen, ob die erste Photovoltaikzelle einem Teilmodul angehört, das mindestens eine Zelle im gesunden Zustand umfasst, oder einem Teilmodul, das keine Zelle im gesunden Zustand umfasst.

**13.** System nach Anspruch 12, **dadurch gekennzeichnet, dass** es:

- wenn die erste Photovoltaikzelle einem Teilmodul angehört, das mindestens eine Zelle im gesunden Zustand umfasst, dazu ausgelegt ist, auszuführen:
  ◦ ein Modul zum Vergleichen der Temperatur der ersten Zelle mit der Referenztemperatur, um zu bestimmen, ob die Temperatur der ersten Zelle über der Referenztemperatur oder unter der Referenztemperatur liegt.

**14.** System nach Anspruch 13, **dadurch gekennzeichnet, dass** es:

- wenn die Temperatur der ersten Photovoltaikzelle unter der Referenztemperatur liegt, dazu ausgelegt ist, eine Suchschleife zum Suchen der der ersten Photovoltaikzelle zugeordneten U-I-Kennlinie auszuführen, wobei die Suchschleife umfasst:

  ◦ einen Schritt des Ansetzens einer ersten Bestrahlungsstärke;
  ◦ einen Schritt des Bestimmens, in der U-I-Kennlinien-Datenbank, einer ersten U-I-Kennlinie, die der ersten Bestrahlungsstärke und der Temperatur der ersten Photovoltaikzelle entspricht;
  ◦ anhand der ersten Kennlinie, einen Schritt des Bestimmens der Spannung, die dem Strom im maximalen Arbeitspunkt entspricht;
  ◦ einen Schritt des Überprüfens der folgenden Gleichung:

$$G = P_{th\_cell\_k} + I_{mpp} \times V(I_{mpp})$$

in der:

- G der als Eingangsgröße eingegebenen ersten Bestrahlungsstärke entspricht;
- $P_{th\_cell\_k}$ der von der ersten Photovoltaikzelle erzeugten thermischen Leistung entspricht;
- $I_{mpp}$ dem Strom im maximalen Arbeitspunkt entspricht;
- $V(I_{mpp})$ der Spannung entspricht, die in der ersten U-I-Kennlinie für den Strom im maximalen Arbeitspunkt bestimmt wurde;

  ◦ wenn die Gleichung erfüllt ist, ist die U-I-Kennlinie gültig;
  ◦ wenn die Gleichung nicht erfüllt ist, wird die Schleife wiederholt, wobei der als Eingangsgröße angesetzte Wert der Bestrahlungsstärke geändert wird.

**15.** System nach Anspruch 13 oder 14, **dadurch gekennzeichnet, dass** es:

- wenn die Temperatur der ersten Photovoltaikzelle über der Referenztemperatur liegt, dazu ausgelegt ist, auszuführen:

  ◦ ein Modul zum Bestimmen der Spannung der ersten defekten Photovoltaikzelle anhand der folgenden Gleichung:

$$V_{cell\_k} = V_{mpp} - \Delta P_{th\_cell\_k}/I_{mpp}$$

in der:

- $V_{cell\_k}$ der Spannung der ersten Photovoltaikzelle entspricht;
- $V_{mpp}$ der Spannung im maximalen Arbeitspunkt entspricht;

- $\Delta P_{th\_cell\_k}$ den energetischen Verlusten entspricht, die durch die erste defekte Photovoltaikzelle verursacht werden;
  - $I_{mpp}$ dem Strom im maximalen Arbeitspunkt entspricht;

○ ein Modul zum Suchen, in der U-I-Kennlinien-Datenbank, der U-I-Kennlinie, die einer Referenzbestrahlungsstärke entspricht und bei welcher der Punkt, dessen Koordinaten die für die erste Photovoltaikzelle bestimmte Spannung und der Strom im maximalen Arbeitspunkt sind, der Kennlinie angehört.

**16.** System nach Anspruch 12, **dadurch gekennzeichnet, dass** es:

- wenn die erste Photovoltaikzelle einem Teilmodul angehört, das keine Zelle im gesunden Zustand umfasst, dazu ausgelegt ist, auszuführen:
○ ein Modul zum Bestimmen, ob alle Zellen ihres Teilmoduls eine elektrische Leistung von null aufweisen oder ob mindestens eine Zelle des Teilmoduls eine elektrische Leistung ungleich null aufweist.

**17.** System nach Anspruch 16, **dadurch gekennzeichnet, dass** es:

- wenn alle Zellen ihres Teilmoduls eine elektrische Leistung von null aufweisen, dazu ausgelegt ist, auszuführen:
○ ein Modul zum Schätzen der der ersten Photovoltaikzelle zugeordneten U-I-Kennlinie durch Suchen, in einer U-I-Kennlinien-Datenbank, einer U-I-Kennlinie, die definiert ist durch $\{(I,V)$ so dass $I \geq 0$ und $V = 0\}$ und $\{(I,V)$ so dass $I = 0$ und $V \geq 0\}$.

**18.** System nach Anspruch 16 oder 17, **dadurch gekennzeichnet, dass** es:

- wenn mindestens eine Zelle des Teilmoduls eine elektrische Leistung ungleich null aufweist dazu ausgelegt ist, eine Suchschleife zum Suchen der der ersten Photovoltaikzelle zugeordneten U-I-Kennlinie durchzuführen, wobei die Suchschleife umfasst:

○ einen Schritt des Ansetzens eines ersten Stroms;
○ einen Schritt des Bestimmens der Spannung der Zelle für jede Photovoltaikzelle des Teilmoduls anhand der folgenden Gleichung:

$$V_{cell\_k}(I_{in}) = (P_{elec\_sain} - \Delta P_{th\_cell\_k})/I_{in}$$

in der:

- $V_{cell\_k}$ der Spannung jeder Photovoltaikzelle des Teilmoduls entspricht, mit k=1 bis n Photovoltaikzellen in dem Teilmodul;
- $I_{in}$ dem als Eingangsgröße angesetzten ersten Strom entspricht;
- $P_{elec\_sain}$ der von einer Photovoltaikzelle in einem gesunden Zustand abgegebenen Leistung entspricht;
- $\Delta P_{th\_cell\_k}$ den energetischen Verlusten entspricht, die durch jede defekte Photovoltaikzelle verursacht werden;

○ einen Schritt des Bestimmens der Summe aus den Spannungen aller Photovoltaikzellen des Teilmoduls;
○ einen Schritt des Überprüfens, ob diese Summe null oder ungleich null ist;
○ wenn die Summe null ist:
- einen Schritt des Schätzens der der ersten Photovoltaikzelle zugeordneten U-I-Kennlinie durch Suchen, in einer U-I-Kennlinien-Datenbank, einer U-I-Kennlinie, bei welcher der Punkt, dessen Koordinaten die für die erste Photovoltaikzelle bestimmte Spannung und der als Eingangsgröße angesetzte erste Strom sind, der Kennlinie angehört;
○ wenn die Summe ungleich null ist:
- einen Schritt des Änderns des als Eingangsgröße angesetzten ersten Stroms und des erneuten Durchführens der Suchschleife unter Berücksichtigung des geänderten ersten Stroms.

**Claims**

1. Method for the electrical characterization of a photovoltaic cell of a photovoltaic module (Mi), said photovoltaic module including a plurality of photovoltaic cells connected to one another and one or more bypass diodes, each bypass diode being configured to bypass a submodule formed of one or more photovoltaic cells of said photovoltaic module, including steps of:

    - Obtaining the irradiance received by said photovoltaic module,
    - Obtaining a temperature of each photovoltaic cell of a first submodule of said photovoltaic module,
    - Comparing said temperature obtained for each photovoltaic cell of the first submodule with a reference temperature (Tref),
    - Determining the state of each photovoltaic cell of the first submodule between a healthy state, in which its temperature is equal to the reference temperature, and a faulty state, in which its temperature is different from said reference temperature,
    - Estimating the I-V curve associated with a first photovoltaic cell of said first submodule, by searching in a database of I-V curves, taking into account:

        ◦ The healthy state or the faulty state of said first photovoltaic cell;
        ◦ The healthy state or the faulty state of all of the other photovoltaic cells of the first submodule;
        ◦ The electric power supplied by each photovoltaic cell of the first submodule.

2. Method according to Claim 1, **characterized in that**:

    - If the first photovoltaic cell is in said faulty state, it includes a step of:
    ◦ Determining whether the first photovoltaic cell belongs to a string of modules in which all of the photovoltaic cells are in the faulty state or whether the first photovoltaic cell belongs to a string of modules in which at least one photovoltaic cell is in a healthy state.

3. Method according to Claim 2, **characterized in that**:

    - If the first photovoltaic cell belongs to a string of modules in which at least one photovoltaic cell is in a healthy state, it includes a step of:
    ◦ Determining whether the first photovoltaic cell belongs to a submodule that includes at least one cell in the healthy state or to a submodule that does not include any cells in the healthy state.

4. Method according to Claim 3, **characterized in that**:

    - If the first photovoltaic cell belongs to a submodule that includes at least one cell in the healthy state, it includes a step of:
    ◦ Comparing the temperature of the first cell with said reference temperature in order to determine whether said temperature of the first cell is higher than said reference temperature or lower than said reference temperature.

5. Method according to Claim 4, **characterized in that**:

    - If the temperature of the first photovoltaic cell is lower than the reference temperature, it consists in implementing a loop of searching for the I-V curve associated with said first photovoltaic cell, said search loop comprising:

        ◦ A step of applying a first irradiance;
        ◦ A step of determining, in the database of I-V curves, a first I-V curve corresponding to said first irradiance and to said temperature of the first photovoltaic cell;
        ◦ On the basis of said first curve, a step of determining the voltage that corresponds to the current at the maximum power point;
        ◦ A step of satisfying the following relationship:

$$G = P_{th\_cell\_k} + I_{mpp} \times V(I_{mpp})$$

In which:

- G corresponds to said first irradiance introduced at input;
- $P_{th\_cell\_k}$ corresponds to the thermal power generated by said first photovoltaic cell;
- $I_{mpp}$ corresponds to the current at the maximum power point;
- $V(I_{mpp})$ corresponds to the voltage determined on said first I-V curve for said current at the maximum power point;

  ◦ If said relationship is satisfied, said I-V curve is valid;
  ◦ If said relationship is not satisfied, said loop is restarted while modifying the irradiance value applied at input.

**6.** Method according to Claim 4 or 5, **characterized in that**:

- If the temperature of the first photovoltaic cell is higher than the reference temperature, it includes:

  ◦ A step of determining the voltage of the faulty first photovoltaic cell from the following relationship:

$$V_{cell\_k} = V_{mpp} - \Delta P_{th\_cell\_k}/I_{mpp}$$

In which:

- $V_{cell\_k}$ corresponds to the voltage of the first photovoltaic cell;
- $V_{mpp}$ corresponds to the voltage at the maximum power point;
- $\Delta P_{th\_cell\_k}$ corresponds to the energy losses caused by the faulty first photovoltaic cell;
- $I_{mpp}$ corresponds to the current at the maximum power point;

  ◦ A step of searching, in the database of I-V curves, for the I-V curve that corresponds to a reference irradiance, and for which the point whose coordinates are said voltage determined for the first photovoltaic cell and the current at the maximum power point belongs to the curve.

**7.** Method according to Claim 3, **characterized in that**:

- If the first photovoltaic cell belongs to a submodule that does not include any cells in the healthy state, it includes a step of:
  ◦ Determining whether all of the cells of its submodule have zero electric power or whether at least one cell of said submodule has a nonzero electric power.

**8.** Method according to Claim 7, **characterized in that**:

- If all of the cells of its submodule have zero electric power, it includes a step of:
  ◦ Estimating the I-V curve associated with said first photovoltaic cell by searching, in a database of I-V curves, for an I-V curve defined by {($I,V$) *such that* $I \geq 0$ *and* $V = 0$} and {($I,V$) *such that* $I = 0$ *and* $V \geq 0$}.

**9.** Method according to Claim 7 or 8, **characterized in that**:

- If at least one cell of said submodule has a nonzero electric power, it consists in implementing a loop of searching for the I-V curve associated with said first photovoltaic cell, said search loop comprising:

  ◦ A step of applying a first current;
  ◦ A step of determining, for each photovoltaic cell of said submodule, the voltage of the cell from the following relationship:

$$V_{cell\_k}(I_{in}) = (P_{elec\_healthy} - \Delta P_{th\_cell\_k})/I_{in}$$

In which:

$V_{cell\_k}$ corresponds to the voltage of each photovoltaic cell of said submodule, where k=1 to n photovoltaic cells in the submodule;

- $I_{in}$ corresponds to said first current applied at input;
- $P_{elec\_healthy}$ corresponds to the power supplied by a photovoltaic cell in a healthy state;
- $\Delta P_{th\_cell\_k}$ corresponds to the energy losses caused by each faulty photovoltaic cell;

◦ A step of determining the sum of the voltages of all of the photovoltaic cells of the submodule;
◦ A step of checking whether said sum is zero or nonzero;
◦ If said sum is zero:
- A step of estimating the I-V curve associated with said first photovoltaic cell by searching, in a database of I-V curves, for an I-V curve for which the point whose coordinates are said voltage determined for the first photovoltaic cell and the first current applied at input belongs to the curve;
◦ If said sum is nonzero;
- A step of modifying the first current applied at input and of implementing said search loop again, taking into account the modified first current.

10. System for the electrical characterization of a photovoltaic cell of a photovoltaic module (Mi), said photovoltaic module including a plurality of photovoltaic cells connected to one another and one or more bypass diodes, each bypass diode being configured to bypass a submodule formed of one or more photovoltaic cells of said photovoltaic module, including:

- A module for obtaining the irradiance received by said photovoltaic module,
- A module for obtaining a temperature of each photovoltaic cell of a first submodule of said photovoltaic module,
- A module for comparing said temperature obtained for each photovoltaic cell of the first submodule with a reference temperature (Tref),
- A module for determining the state of each photovoltaic cell of the first submodule between a healthy state, in which its temperature is equal to the reference temperature, and a faulty state, in which its temperature is different from said reference temperature,
- A module for estimating the I-V curve associated with a first photovoltaic cell of said first submodule, by searching in a database of I-V curves, taking into account:

◦ The healthy state or the faulty state of said first photovoltaic cell;
◦ The healthy state or the faulty state of all of the other photovoltaic cells of the first submodule;
◦ The electric power supplied by each photovoltaic cell of the first submodule.

11. System according to Claim 10, **characterized in that**:

- If the first photovoltaic cell is in said faulty state, it is configured to execute:
◦ A module for determining whether the first photovoltaic cell belongs to a string of modules in which all of the photovoltaic cells are in the faulty state or whether the first photovoltaic cell belongs to a string of modules in which at least one photovoltaic cell is in a healthy state.

12. System according to Claim 11, **characterized in that**:

- If the first photovoltaic cell belongs to a string of modules in which at least one photovoltaic cell is in a healthy state, it is configured to execute:
◦ A module for determining whether the first photovoltaic cell belongs to a submodule that includes at least one cell in the healthy state or to a submodule that does not include any cells in the healthy state.

13. System according to Claim 12, **characterized in that**:

- If the first photovoltaic cell belongs to a submodule that includes at least one cell in the healthy state, it is configured to execute:
◦ A module for comparing the temperature of the first cell with said reference temperature in order to determine whether said temperature of the first cell is higher than said reference temperature or lower than said reference temperature.

14. System according to Claim 13, **characterized in that**:

- If the temperature of the first photovoltaic cell is lower than the reference temperature, it is configured to execute a loop of searching for the I-V curve associated with said first photovoltaic cell, said search loop comprising:

◦ A step of applying a first irradiance;
◦ A step of determining, in the database of I-V curves, a first I-V curve corresponding to said first irradiance and to said temperature of the first photovoltaic cell;
◦ On the basis of said first curve, a step of determining the voltage that corresponds to the current at the maximum power point;
◦ A step of satisfying the following relationship:

$$G = P_{th\_cell\_k} + I_{mpp} \times V(I_{mpp})$$

In which:

- G corresponds to said first irradiance introduced at input;
- $P_{th\_cell\_k}$ corresponds to the thermal power generated by said first photovoltaic cell;
- $I_{mpp}$ corresponds to the current at the maximum power point;
- $V(I_{mpp})$ corresponds to the voltage determined on said first I-V curve for said current at the maximum power point;

◦ If said relationship is satisfied, said I-V curve is valid;
◦ If said relationship is not satisfied, said loop is restarted while modifying the irradiance value applied at input.

**15.** System according to Claim 13 or 14, **characterized in that**:

- If the temperature of the first photovoltaic cell is higher than the reference temperature, it is configured to execute:

◦ A module for determining the voltage of the faulty first photovoltaic cell from the following relationship:

$$V_{cell\_k} = V_{mpp} - \Delta P_{th\_cell\_k}/I_{mpp}$$

In which:

- $V_{cell\_k}$ corresponds to the voltage of the first photovoltaic cell;
- $V_{mpp}$ corresponds to the voltage at the maximum power point;
- $\Delta P_{th\_cell\_k}$ corresponds to the energy losses caused by the faulty first photovoltaic cell;
- $I_{mpp}$ corresponds to the current at the maximum power point;

◦ A module for searching, in the database of I-V curves, for the I-V curve that corresponds to a reference irradiance, and for which the point whose coordinates are said voltage determined for the first photovoltaic cell and the current at the maximum power point belongs to the curve.

**16.** System according to Claim 12, **characterized in that**:

- If the first photovoltaic cell belongs to a submodule that does not include any cells in the healthy state, it is configured to execute:
◦ A module for determining whether all of the cells of its submodule have zero electric power or whether at least one cell of said submodule has a nonzero electric power.

**17.** System according to Claim 16, **characterized in that**:

- If all of the cells of its submodule have zero electric power, it is configured to execute:
◦ A module for estimating the I-V curve associated with said first photovoltaic cell by searching, in a database of I-V curves, for an I-V curve defined by {(I,V) *such that I ≥ 0 and V = 0*} and {(I,V) *such that I = 0 and V ≥ 0*}.

29

18. System according to Claim 16 or 17, **characterized in that**:

- If at least one cell of said submodule has a nonzero electric power, it is configured to implement a loop of searching for the I-V curve associated with said first photovoltaic cell, said search loop comprising:

◦ A step of applying a first current;
◦ A step of determining, for each photovoltaic cell of said submodule, the voltage of the cell from the following relationship:

$$V_{cell\_k}(I_{in}) = (P_{elec\_healthy} - \Delta P_{th\_cell\_k})/I_{in}$$

In which:

- $V_{cell\_k}$ corresponds to the voltage of each photovoltaic cell of said submodule, where k=1 to n photovoltaic cells in the submodule;
- $I_{in}$ corresponds to said first current applied at input;
- $P_{elec\_healthy}$ corresponds to the power supplied by a photovoltaic cell in a healthy state;
- $\Delta P_{th\_cell\_k}$ corresponds to the energy losses caused by each faulty photovoltaic cell;

◦ A step of determining the sum of the voltages of all of the photovoltaic cells of the submodule;
◦ A step of checking whether said sum is zero or nonzero;
◦ If said sum is zero:
- A step of estimating the I-V curve associated with said first photovoltaic cell by searching, in a database of I-V curves, for an I-V curve for which the point whose coordinates are said voltage determined for the first photovoltaic cell and the first current applied at input belongs to the curve;
◦ If said sum is nonzero;
- A step of modifying the first current applied at input and of implementing said search loop again, taking into account the modified first current.

**Fig. 1**

Fig. 2

**Fig. 3**

**Fig. 4**

**Fig. 5**

**Fig. 6A**

Mi

Img

60

3

**Fig. 6B**

61

61

3

*Fig. 7*

```
┌──────────┐
│    E1    │
└──────────┘
      │
      ▼
┌──────────┐
│    E2    │
└──────────┘
      │
      ▼
┌──────────┐
│    E3    │
└──────────┘
      │
      ▼
┌──────────┐
│    E4    │
└──────────┘
      │
      ▼
┌──────────┐
│    E5    │
└──────────┘
      │
      ▼
┌──────────┐
│    E6    │
└──────────┘
      │
      ▼
┌──────────┐
│    E7    │
└──────────┘
      │
      ▼
┌──────────┐
│    E8    │
└──────────┘
```

**Fig. 8**

```
                      ┌──────────┐
                      │    E8    │
                      └──────────┘
              ┌───────────────────────┐
        ┌──────────┐            ┌──────────┐
        │   E80    │            │   E81    │
        └──────────┘            └──────────┘
                         ┌────────────────────┐
                   ┌──────────┐         ┌──────────┐
                   │   E810   │         │   E811   │
                   └──────────┘         └──────────┘
                                  ┌────────────────────┐
                            ┌──────────┐         ┌──────────┐
                            │  E812a   │         │  E812b   │
                            └──────────┘         └──────────┘
```

**Fig. 9A**

┌──────────┐      ┌────────────────────────┐
│   E810   │      │  $T_{cell\_k} < T_{sain}$  │
└──────────┘      └────────────────────────┘

```
                    ┌──────────┐  B1
              ┌────►│  G_in    │
              │     └──────────┘
              │          │
        ┌──────────┐  B7  ▼
        │G_in=G_in+X│   ┌──────────┐  B2
        └──────────┘    │  D_IV    │◄── T_cell_k
              ▲          └──────────┘
        ┌──────────┐  B6      │
        │  I-Vk    │          ▼
        │  NOK     │      ┌──────────┐  B3
        └──────────┘      │  I-Vk    │◄── I_mpp
              ▲           └──────────┘
              │               │
              │               ▼           B4
              │ N       ◇─────────────────◇
              └────────◇ G=P_th_cell_k +I_mpp×V(I_mpp)? ◇
                        ◇─────────────────◇
                              │ Y
                              ▼
                          ┌──────────┐  B5
                          │  I-Vk    │
                          │  OK      │
                          └──────────┘
```

**Fig. 9B**

E810

$$T_{cell\_k} > T_{sain}$$

$$T_{cell\_k} \qquad B12$$

I-V sain $\qquad$ B10

$$\Delta P_{th\_cell\_k} \qquad B13$$

$$I_{mpp}$$
$$V_{mpp} \qquad B11$$

$$B14$$

$$I_{cell\_k} = I_{mpp}$$

$$V_{cell\_k} = V_{mpp} - \Delta P_{th\_cell\_k} / I_{mpp}$$

D_IV

B16

I-V OK $\qquad$ B17

$$G_{sain} \qquad B15$$

*Fig. 10*

```
┌─────────────┐ ⤳ B100          ┌─────────────┐ ⤳ B102
│   I-V sain  │                 │  T_cell _ k │
└──────┬──────┘                 └──────┬──────┘
       │                               │
       ▼                               ▼
┌─────────────┐ ⤳ B101          ┌─────────────┐ ⤳ B103
│   I_mpp     │                 │ ΔP_th_cell_k│
│   V_mpp     │                 └──────┬──────┘
└──────┬──────┘                        │
       │                               ▼
       │                        ┌─────────────┐ ⤳ B104
       └───────────────────────▶│    B104     │
                                └──────┬──────┘
                          ┌────────────┴────────────┐
                          ▼                         ▼
                   ┌─────────────┐           ┌─────────────┐
                   │    E812b    │           │    E812a    │
                   └──────┬──────┘           └─────────────┘
                          ▼
                   ┌─────────────┐ ⤳ B105
            ┌─────▶│    I_in     │
            │      └──────┬──────┘
            │             ▼
  B108      │      ┌─────────────┐ ⤳ B106   ┌─────────────┐
   ⤳        │      │             │          │    k = 1    │
┌───────────────┐ │ V_cell_k(I_in)│◀────────│     à       │
│ I_in = I_in+X │ │             │          │    k = n    │
└───────────────┘ └──────┬──────┘          └─────────────┘
         ▲ N             ▼                  B107 ⤳
         │        ◇───────────────◇
         └────────│ ΣV_cell_k = 0? │
                  ◇───────┬───────◇
                          │ Y
                          ▼
                   ┌─────────────┐
                   │  I_cell _ k │
                   │  V_cell _ k │
                   └──────┬──────┘
                          │
 T_cell _ k ──▶ ┌──────┐  ▼
                │ D_IV │─▶┌─────────────┐
                └──────┘  │    B109     │
                          └──────┬──────┘
                                 ▼
                          ┌─────────────┐ ⤳ B110
                          │    I-Vk     │
                          │     OK      │
                          └─────────────┘
```

$$I_{mpp}$$
$$V_{mpp}$$

$$T_{cell\_k}$$

$$\Delta P_{th\_cell\_k}$$

$$I_{in}$$

$$I_{in} = I_{in} + X$$

$$V_{cell\_k}(I_{in})$$

$$k = 1$$
$$à$$
$$k = n$$

$$\sum V_{cell\_k} = 0?$$

$$I_{cell\_k}$$
$$V_{cell\_k}$$

$$T_{cell\_k}$$

## RÉFÉRENCES CITÉES DANS LA DESCRIPTION

**Documents brevets cités dans la description**

- US 2015094967 A
- US 2015094967 A1
- WO 2012128807 A1
- FR 2956213 A1
- WO 2010118952 A1
- US 9048781 B2
- US 2014266294 A1
- WO 2016189052 A1